# EUROPEAN PATENT APPLICATION

(11) **EP 4 742 518 A1**
(43) Date of publication of application: **13.05.2026**
(21) Application number: 24792109.1
(22) Date of filing: 19.04.2024
(51) Int. Cl.: H02K 35/02, G03B 17/56

(54) **SELF-RESETTING MAGNETIC SUSPENSION POWER GENERATOR, AND POWER GENERATION METHOD, RESETTING METHOD AND USE THEREOF**

(30) Priority: 20.04.2023 CN 202310428493
(71) Applicant: GUANGDONG EBELONG INTELLIGENT TECHNOLOGY CO., LTD, Shenzhen, Guangdong 518126 (CN)
(72) Inventor: LIU, Yuanfang, Shenzhen, Guangdong 518126 (CN)
(74) Representative: Fry, David John
(86) International application number: PCT/CN2024/088728
(87) International publication number: WO 2024/217524

(57) **Abstract**

The present invention provides a self-resetting magnetic suspension power generator, and a power generation method, resetting method and use thereof. The self-resetting magnetic suspension power generator comprises a hollow coil, a magnetic suspension assembly and a housing; the housing comprises a top cover, a bottom cover, and a power generation cavity defined by the top cover and the bottom cover; the hollow coil is accommodated in the power generation cavity; the top cover is provided with a driving hole; the driving hole is communicated with a hollow channel defined by the hollow coil to form a magnetic suspension channel; when stressed or pressed, the magnetic suspension assembly moves along the magnetic suspension channel, so that a change of magnetic flux of magnetic induction lines of the hollow coil is formed to generate electric energy; the magnetic suspension assembly and the top cover attract each other under a magnetic attraction effect so that the magnetic suspension assembly is suspended in the magnetic suspension channel, and the magnetic suspension assembly is reset when the stress is removed, so as to re-form the change of the magnetic flux of the magnetic induction lines of the hollow coil during the resetting to generate electric energy.

## Description

### Technical Field

The present invention relates to the field of self-power generation, and in particular to a self-resetting magnetic suspension power generator, as well as its power generation method, resetting method and application.

### Background Art

With the development of science and technology and social progress, more and more electrical equipment has entered people's lives, and the number of controllers used to control various types of electrical equipment has increased correspondingly. For example, traditional switch controllers used to control lamp switches are mostly wired switches, which are inconvenient for wiring, increase the installation cost of the corresponding electrical equipment, and affect the aesthetic appearance of the corresponding environment. With the development of science and technology, wireless control methods have increasingly appeared in people's lives, such as remote controls and other wireless control devices. People have become accustomed to using remote controls and other wireless control devices to control corresponding electrical equipment. However, most of the existing wireless control devices such as remote controls are powered by batteries. As a result, under the current trend of the popularity of wireless control devices, the usage of batteries has also increased significantly. In many families, various remote controls are scattered to control various electrical equipment, and each remote control needs to be equipped with corresponding batteries. Moreover, after a certain period of use, the batteries need to be replaced in batches, which additionally increases the cost of battery preparation. At the same time, driven by the current environmental protection concepts and policies, the large-scale additional use of batteries is contrary to environmental protection concepts and policies. Additionally, the replacement of batteries causes resource waste and environmental pollution, which is inconsistent with the concepts of green, environmental protection and low carbon.

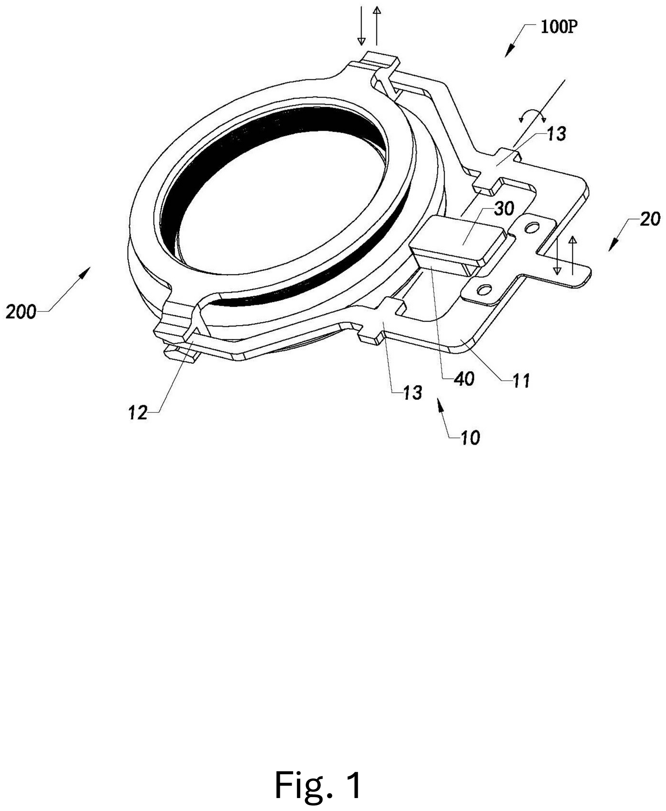

At present, passive technology is a recognized solution to solve the problem of battery consumption and waste in such control devices. For example, the Chinese Invention Patent with the announcement number CN104901505B discloses a conversion structure for converting kinetic energy into electrical energy and wireless electronic products. However, these micro-generator structures have the problem of large volume and cannot meet the usage requirements of some smaller volumes, and also have extremely high manufacturing precision requirements. In this patent, due to the alternating impact of two magnetic conductive plates with the connecting plate, strong impact noise is generated. Moreover, this power generation method relying on the up and down impact of magnets on the magnetic conductive plates has little effect on the magnetic force generated by the coil, resulting in low power generation efficiency. Furthermore, in this structure, the magnet group needs to be fixedly connected with the elastic sheet, and external mechanical structures are relied on to maintain left-right balance. It is not a structure that can fix itself and maintain balance only by using its own magnetic force. If the balance is lost, the output energy will be unstable, so the structure is relatively complex. The magnetic pole switching type micro-generators in the existing passive technology are all bistable, and adopt a driving mode of N-S two magnetic pole switching. That is, they have two stable states: the N pole is adsorbed to the magnetic conductive plate and the S pole is adsorbed to the magnetic conductive plate. Electric energy is generated by using external force to switch between these two stable states, and one magnetic pole is always adsorbed to the magnetic conductive plate, resulting in huge impact noise during operation. When such a micro-generator is pressed, it has one stable state, and when it is pushed by an external force in the opposite direction, it has another stable state. If a monostable state is to be implemented, a special spring reset mechanism needs to be provided. In addition to occupying space and incurring costs, the spring reset mechanism also increases the reverse resistance when driving the micro-generator, so that the force required to press the micro-generator is doubled. If a new technology can eliminate the spring reset mechanism to remove the reverse resistance of the spring and improve the pressing feel of the micro-generator, then under the same driving force, the power generation power of the micro-generator can be significantly improved. In the Chinese Invention Patent with the announcement number CN112290739B, a concept of a monostable micro-generator without a reset spring is proposed, but the automatic reset effect of this structure is poor, and it is not a truly fully automatic reset micro-generator. In practical applications, if the movement stroke is greater than 0.5 mm, an auxiliary reset spring is still needed, and this structure cannot generate sufficient driving force to automatically reset the buttons on the housing. Therefore, these defects must be improved. Specifically, referring to Figure 1, the power generation device includes a driving device 100P and a generator 200P. The driving device 100P includes a driving bracket 10P, an energy storage device 20P, at least one brake 30P and at least one magnetic attraction unit 40. The brake 30P is adsorbed to the magnetic attraction unit 40, and the brake 30 conducts the magnetic force of the magnetic attraction unit 40P. The driving bracket 10P includes a driving part 11P, at least one transmission part 12P extending from the driving part 11P, and at least one rotating shaft 13P. In the initial state, the driving part 11P is adsorbed to the brake 30P, and the energy storage device 20P is arranged on the driving part 11P. When the energy storage device 20P stores sufficient driving force, the energy storage device 20P drives the driving part 11P of the driving bracket 10P, so that the driving part 11P is separated from the brake 30P. The driving part 11P and the transmission part 12P are located on both sides of the rotating shaft 13P. When the driving part 11P receives sufficient driving force, the driving part 11P and the transmission part 12P perform an axial rotation movement with the rotating shaft 13P as the axis (fulcrum). The transmission part 12P is drivingly connected to the generator 200P. When the transmission part 12P moves, the transmission part 12P drives the generator 200P to generate induced electrical energy, thereby converting mechanical energy into electrical energy and overcoming the limitation that many control devices need to rely on battery power supply.

However, in many micro-application scenarios, the size of the existing power generation device still cannot meet the application requirements, resulting in many micro-devices still relying on battery power supply. Specifically, the power generation of the power generation device relies on the pivotal movement of the transmission part 12P on the side of the generator 200P, thereby forming a change in the magnetic flux of the magnetic induction lines generated by the hollow coil of the generator 200P to generate electrical potential energy. In order to enable the transmission part 12P to pivot on the side of the generator 200P, the power generation device is provided with the driving part 11P and the rotating shaft 13P that drive the pivotal rotation of the transmission part 12P, so as to drive the transmission part 12P based on the lever principle and increase the kinetic energy of the transmission part 12P to ensure power generation efficiency. At the same time, for the reset of the transmission part 12P, the power generation device also needs to be provided with the energy storage device 20P and the brake 30P. The driving device 100P located on the side of the generator 200P occupies a large part of the area, resulting in a large size of the power generation device. Moreover, the power generation device has a complex structure, a large number of components, high manufacturing costs, great difficulty in miniaturization optimization of the power generation device, and strict requirements on process precision, making it impossible for the existing power generation devices to be further designed in a miniaturized manner.

In the era of smart homes, if the volume of the generator is to be further reduced to adapt to the application of electrical remote controls with extremely short pressing strokes, a new structure needs to be designed to solve the comprehensive defects of the generator in the existing passive technology, such as still large volume, heavy pressing force, loud pressing noise, and long pressing stroke similar to that of piano keys. Therefore, it is necessary to develop a power generator, i.e., a power generation component, which must be very small in size, can solve the above defects, and is suitable for being welded on a printed circuit board (PCB) in a patch manner to be used as a micro-power supply component.

In addition, in the power generation device of the Chinese Invention Patent with the announcement number CN112290739B, the driving device 100P and the brake 30P are arranged in a horizontal distribution, and the magnetic field is not on the same axis, resulting in a narrow coverage range and a small magnetic reset force. When there are buttons outside the housing, there is a lack of sufficient reset force to link the buttons for reset movement, and reliable reset cannot be guaranteed when the reset distance is greater than 0.5 mm. Therefore, a new technical solution is needed to solve these defects.

### Summary of the Invention

One object of the present invention is to provide a self-resetting magnetic suspension power generator, as well as its power generation method, resetting method and application. The self-resetting magnetic suspension power generator arranges its driving device by utilizing the existing position of the hollow coil thereof. In other words, the overall size of the self-resetting magnetic suspension power generator can be set to be close to the size of the hollow coil thereof, overcoming the development bottleneck of miniaturization of the existing power generation devices and realizing the miniaturization of the self-resetting magnetic suspension power generator.

One object of the present invention is to provide a self-resetting magnetic suspension power generator, as well as its power generation method, resetting method and application. The self-resetting magnetic suspension power generator uses very few components to generate sufficient energy to drive the communication circuit to transmit signals, which greatly simplifies the manufacturing process, significantly reduces the production cost, and is conducive to the popularization and application of passive technology.

One object of the present invention is to provide a self-resetting magnetic suspension power generator, as well as its power generation method, resetting method and application. The power generation efficiency of the self-resetting magnetic suspension power generator is effectively improved, and it can meet the power supply demand while being miniaturized.

One object of the present invention is to provide a self-resetting magnetic suspension power generator, as well as its power generation method, resetting method and application. The driving device of the self-resetting magnetic suspension power generator has a small volume and can be automatically reset without using an additional reset device.

One object of the present invention is to provide a self-resetting magnetic suspension power generator, as well as its power generation method, resetting method and application. The driving device of the self-resetting magnetic suspension power generator operates independently relative to the hollow coil, and does not need to be installed or drivingly connected to the hollow coil by means of the hollow coil.

One object of the present invention is to provide a self-resetting magnetic suspension power generator, as well as its power generation method, resetting method and application. The self-resetting magnetic suspension power generator does not need to be additionally provided with a reset spring, and can generate a strong automatic reset force within a large movement stroke only by using the magnetism of the magnet, thereby further being able to push the corresponding external housing buttons to automatically reset. Moreover, without the help of any mechanical connection and fixing method, the corresponding return part can be stably suspended only by using the magnetism of the magnet.

One object of the present invention is to provide a self-resetting magnetic suspension power generator, as well as its power generation method, resetting method and application. The return part of the self-resetting magnetic suspension power generator has a self-adsorbing free magnetic suspension movement state without mechanical connection and fixation, and is not affected by the attachment of other components. Therefore, it has a small mass, and can induce and generate instantaneous energy greater than 200 µJ in the hollow coil when moving at a high speed instantaneously.

One object of the present invention is to provide a self-resetting magnetic suspension power generator, as well as its power generation method, resetting method and application. The self-resetting magnetic suspension power generator has a simple structure and high power generation efficiency, and improves the power generation efficiency while simplifying the structure, overcoming the development bottleneck of the existing power generation devices.

One object of the present invention is to provide a self-resetting magnetic suspension power generator, as well as its power generation method, resetting method and application. The self-resetting magnetic suspension power generator includes a hollow coil, a magnetic suspension assembly and a housing. The magnetic suspension assembly includes a driving part and a return part, and at least one of the driving part and the return part is a permanent magnet. The housing includes a top cover, a bottom cover and a power generation cavity defined by the top cover and the bottom cover. The hollow coil is accommodated in the power generation cavity. The top cover has a driving hole communicating with the power generation cavity, and the driving hole communicates with a hollow channel defined by the hollow coil to form a magnetic suspension channel. The driving part extends into the magnetic suspension channel from the driving hole of the top cover, and the return part is arranged in the magnetic suspension channel. Corresponding to the state where at least one of the driving part and the return part is a permanent magnet, the return part and the top cover have a magnetic attraction force and are adsorbed by the top cover under the magnetic attraction effect, so as to be maintained at an initial position. When the driving part is driven by a force to drive the return part to move along the magnetic suspension channel, a change in the magnetic flux of the hollow coil is formed to generate electrical energy. Corresponding to the return part being suspended in the magnetic suspension channel under the magnetic attraction effect with the top cover, the return part returns to the initial position when the force on the driving part is removed, thereby forming a change in the magnetic flux of the hollow coil again to generate electrical energy.

One object of the present invention is to provide a self-resetting magnetic suspension power generator, as well as its power generation method, resetting method and application. The magnetic suspension assembly of the self-resetting magnetic suspension power generator moves relative to the hollow coil along the magnetic suspension channel to disturb the magnetic induction lines formed by the hollow coil at the center of the hollow coil, thereby improving the power generation efficiency of the self-resetting magnetic suspension power generator.

One object of the present invention is to provide a self-resetting magnetic suspension power generator, as well as its power generation method, resetting method and application. The relative movement direction of the magnetic suspension assembly and the hollow coil of the self-resetting magnetic suspension power generator is an axial movement along the hollow channel defined by the hollow coil, which is different from the pivotal movement mode of the existing power generation devices, thereby improving the disturbance of the magnetic suspension assembly to the magnetic induction lines formed by the hollow coil and improving the power generation efficiency of the self-resetting magnetic suspension power generator.

One object of the present invention is to provide a self-resetting magnetic suspension power generator, as well as its power generation method, resetting method and application. The magnetic suspension assembly of the self-resetting magnetic suspension power generator is arranged in the hollow channel defined by the hollow coil, so as to make full use of the existing size of the self-resetting magnetic suspension power generator, so that the overall size of the self-resetting magnetic suspension power generator can be set to be close to the size of the hollow coil, and the miniaturization of the self-resetting magnetic suspension power generator is realized.

One object of the present invention is to provide a self-resetting magnetic suspension power generator, as well as its power generation method, resetting method and application. The magnetic suspension assembly of the self-resetting magnetic suspension power generator moves in a suspended manner along the magnetic suspension channel, and there is no need to set up a large and complex pivotal movement assembly and reset assembly, thereby realizing the miniaturization of the self-resetting magnetic suspension power generator.

One object of the present invention is to provide a self-resetting magnetic suspension power generator, as well as its power generation method, resetting method and application. The magnetic suspension assembly and the hollow coil of the self-resetting magnetic suspension power generator are independent of each other, and there is no need to set up additional connecting components. That is to say, the magnetic suspension assembly is arranged in a suspended manner relative to the hollow coil, and moves relative to the hollow coil along the suspension channel in a suspended state, simplifying the structural design of the self-resetting magnetic suspension power generator.

One object of the present invention is to provide a self-resetting magnetic suspension power generator, as well as its power generation method, resetting method and application. The magnetic suspension assembly of the self-resetting magnetic suspension power generator moves in a suspended manner in the suspension channel, and there is no need to set up complex pivotal movement components, reset components and connecting components. The self-resetting magnetic suspension power generator has a simple structure, high modularity and integrity of components, reduced production difficulty and process precision requirements, which is conducive to reducing the volume of the self-resetting magnetic suspension power generator, and at the same time reducing the production and manufacturing cost of the self-resetting magnetic suspension power generator and improving the production yield of the self-resetting magnetic suspension power generator.

One object of the present invention is to provide a self-resetting magnetic suspension power generator, as well as its power generation method, resetting method and application. The movement stroke of the magnetic suspension assembly of the self-resetting magnetic suspension power generator enables the return part to maintain a magnetic attraction force with the top cover and automatically reset after the force on the driving part is removed, thereby realizing the self-resetting of the self-resetting magnetic suspension power generator without setting a dedicated reset device, simplifying the structural design of the self-resetting magnetic suspension power generator.

One object of the present invention is to provide a self-resetting magnetic suspension power generator, as well as its power generation method, resetting method and application. The bottom cover of the self-resetting magnetic suspension power generator has a bottom opening communicating with the power generation cavity, and the projection of the driving hole towards the bottom cover is preferably arranged to be located in the bottom opening. In other words, the bottom opening is opposite to and communicates with the hollow channel and is larger than the driving hole, so as to ensure that the return part maintains a magnetic attraction force with the top cover.

One object of the present invention is to provide a self-resetting magnetic suspension power generator, as well as its power generation method, resetting method and application. The top cover of the self-resetting magnetic suspension power generator further includes a driving tube extending from the periphery of the driving hole towards the bottom cover. One end of the driving tube where the driving hole is located is the top end of the driving tube, and the other end of the driving tube is the bottom end of the driving tube. The driving part extends into the driving tube from the top end of the driving tube, and drives the return part located at the bottom end of the driving tube to move away from the top cover when driven by a force. When the force on the driving part is removed, the return part is attracted to the top cover under the magnetic attraction effect and moves towards the top cover, so as to be abutted against the bottom end of the driving tube. In this way, the driving tube is used to guide and limit the movement of the magnetic suspension assembly, ensuring the structural stability of the self-resetting magnetic suspension power generator.

One object of the present invention is to provide a self-resetting magnetic suspension power generator, as well as its power generation method, resetting method and application. The driving tube of the self-resetting magnetic suspension power generator is located in the magnetic suspension channel, thereby forming a solid medium guide for the magnetic circuit in the magnetic suspension channel, so as to improve the power generation efficiency of the self-resetting magnetic suspension power generator. In other words, the arrangement of the driving tube can not only limit and guide the movement of the magnetic suspension assembly, but also be equivalent to arranging a medium in the magnetic suspension channel to guide the magnetic circuit, which not only ensures the structural stability of the self-resetting magnetic suspension power generator, but also improves the power generation efficiency of the self-resetting magnetic suspension power generator.

One object of the present invention is to provide a self-resetting magnetic suspension power generator, as well as its power generation method, resetting method and application. The driving tube of the self-resetting magnetic suspension power generator is located in the magnetic suspension channel, thereby increasing the inductance of the hollow coil to further enhance the magnetic flux BL value between the magnetic field and the hollow coil, so that the magnetic strength of the magnetic field acting on the hollow coil is significantly increased, thus improving the power generation efficiency of the self-resetting magnetic suspension power generator. Even after the self-resetting magnetic suspension power generator is designed to be miniaturized compared with the existing generators, its power generation efficiency can still be improved, and it has strong power generation energy after being designed to be miniaturized. Therefore, the driving tube has multiple beneficial effects of increasing the magnetic field strength to enhance the power generation efficiency, forming a solid medium guide and positioning for the magnetic circuit, forming a solid medium movement limit and guide for the magnetic suspension assembly, and attracting and resetting the magnetic suspension assembly.

One object of the present invention is to provide a self-resetting magnetic suspension power generator, as well as its power generation method, resetting method and application. The hollow coil of the self-resetting magnetic suspension power generator is preferably arranged in a ring shape, and the corresponding driving part is preferably arranged in a cylindrical or cylindrical-like shape, and the return part is arranged in a circular sheet shape. Thus, when the magnetic suspension assembly moves relative to the hollow coil, the disturbance to the magnetic induction lines in all directions is uniform, ensuring the uniformity of the electric quantity generated during the power generation process of the self-resetting magnetic suspension power generator.

One object of the present invention is to provide a self-resetting magnetic suspension power generator, as well as its power generation method, resetting method and application. When the return part of the self-resetting magnetic suspension power generator realizes the magnetic attraction reset of the magnetic suspension assembly, it also disturbs the hollow coil to generate power, which can not only reset but also further generate power, so as to improve the power generation efficiency of the self-resetting magnetic suspension power generator.

One object of the present invention is to provide a self-resetting magnetic suspension power generator, as well as its power generation method, resetting method and application. The magnetic suspension assembly of the self-resetting magnetic suspension power generator further includes an energy storage part. Before the driving part is driven by a force to drive the return part and overcome the magnetic attraction force between the return part and the top cover, the energy storage part stores potential energy and forms a force-bearing displacement of the driving part, thereby avoiding the sudden displacement of the driving part at the moment of overcoming the magnetic attraction force between the return part and the top cover and improving the pressing feel of the self-resetting magnetic suspension power generator.

One object of the present invention is to provide a self-resetting magnetic suspension power generator, as well as its power generation method, resetting method and application. The self-resetting magnetic suspension power generator has high power generation efficiency while being miniaturized, so it is suitable for various micro-application scenarios, such as being embedded in a selfie stick to form a self-powered selfie stick device. When a user presses the photographing button of the self-powered selfie stick device, the self-resetting magnetic suspension power generator is driven to generate power to supply power for sending a corresponding photographing instruction, avoiding the environmental protection problems caused by battery power supply and the inconvenience of frequent replacement or charging. At the same time, the requirements for the use environment are significantly reduced, ensuring the use safety of the selfie stick in most outdoor application scenarios. Moreover, based on the maintenance-free feature of the self-powered selfie stick device, the embarrassing situation of power exhaustion during outdoor use is avoided.

According to one aspect of the present invention, the present invention provides a self-resetting magnetic suspension power generator, which includes:
- A hollow coil, wherein the hollow coil defines a hollow channel;
- A magnetic suspension assembly, wherein the magnetic suspension assembly includes a driving part and a return part, and at least one of the driving part and the return part is a permanent magnet; and
- A housing, wherein the housing includes a top cover, a bottom cover and a power generation cavity defined by the top cover and the bottom cover, the hollow coil is accommodated in the power generation cavity, the top cover has a driving hole communicating with the power generation cavity, in the state where the hollow coil is accommodated in the power generation cavity, the driving hole communicates with the hollow channel to form a magnetic suspension channel, the driving part extends into the magnetic suspension channel from the driving hole of the top cover, the return part is arranged in the magnetic suspension channel, and is adsorbed to the top cover under magnetic attraction to be maintained at an initial position in the state where at least one of the driving part and the return part is a permanent magnet. When the driving part is driven by a force to drive the return part to move along the magnetic suspension channel, a change in the magnetic flux of the hollow coil is formed to generate electrical energy. Corresponding to the return part being suspended in the magnetic suspension channel under the magnetic attraction effect with the top cover, the return part returns to the initial position when the force on the driving part is removed.

In one embodiment, the top cover further includes a driving tube extending from the periphery of the driving hole towards the bottom cover. One end of the driving tube where the driving hole is located is the top end of the driving tube, and the other end of the driving tube is the bottom end of the driving tube. The driving part extends into the driving tube from the top end of the driving tube, and drives the return part located at the bottom end of the driving tube to move away from the top cover when driven by a force. When the force on the driving part is removed, the return part is attracted to the top cover under the magnetic attraction effect and moves towards the top cover, so as to be abutted against the bottom end of the driving tube.

In one embodiment, the bottom cover is a closed cover, and the movement stroke of the magnetic suspension assembly enables the magnetic attraction force between the return part and the top cover to be greater than the magnetic attraction force between the return part and the bottom cover.

In one embodiment, the bottom cover has a bottom opening communicating with the power generation cavity, and the movement stroke of the magnetic suspension assembly enables the magnetic attraction force between the return part and the top cover to be greater than the magnetic attraction force between the return part and the bottom cover.

In one embodiment, the projection of the driving hole towards the bottom cover is located in the bottom opening.

In one embodiment, the return part is a permanent magnet.

In one embodiment, the driving part is a non-magnetic conductor and abuts against the return part.

In one embodiment, both the return part and the driving part are permanent magnets.

In one embodiment, the return part and the driving part are of an integrated structure.

In one embodiment, the driving part is a permanent magnet, and the return part is a magnetic conductor to conduct the magnetic force of the driving part so as to ensure the magnetic attraction force with the top cover.

In one embodiment, the magnetic suspension assembly further includes an energy storage part. Before the driving part is driven by a force to drive the return part and overcome the magnetic attraction force between the return part and the top cover, the energy storage part stores potential energy and forms a force-bearing displacement of the driving part.

In one embodiment, the energy storage part is arranged between the driving part and the return part.

In one embodiment, the energy storage part is arranged at one end of the driving part far away from the return part.

In one embodiment, one end of the driving part close to the return part is provided with a driving groove recessed towards the other end of the driving part, and the energy storage part is accommodated in the driving groove and presses against the return part.

In one embodiment, the hollow coil is arranged in a ring shape.

In one embodiment, the driving part is arranged in a cylindrical or cylindrical-like shape, and the return part is arranged in a circular sheet shape.

In one embodiment, the diameter of the return part is larger than the aperture of the driving hole.

In one embodiment, one end of the driving part far away from the return part is arranged in a conical shape, so as to facilitate pressing the self-resetting magnetic suspension power generator.

In one embodiment, the hollow coil is arranged in a rectangular or irregular shape.

In one embodiment, the top cover includes a first magnetic wall, and a second magnetic wall and a third magnetic wall extending downward from the first magnetic wall, and the center of the first magnetic wall is hollowed out to form the driving hole.

In one embodiment, the bottom cover includes a bottom magnetic wall and a side magnetic wall extending upward from the edge of the bottom magnetic wall and perpendicular to the bottom magnetic wall. The second magnetic wall of the top cover and the side magnetic wall of the bottom cover are directly abutted against or close to each other, so that the two-pole magnetic field of the return part is fully collected and utilized, which has the dual beneficial effects of improving power generation efficiency and protecting internal components.

According to another aspect of the present invention, the present invention provides a self-powered selfie stick, which includes:
- A clamping part;
- A handle part, wherein the clamping part is installed on the handle part; and
- A self-resetting power generator, wherein the self-resetting power generator is arranged on the handle part, the self-resetting power generator is electrically connected to a communication circuit, and the communication circuit can transmit wireless signals to control a mobile terminal device clamped on the clamping part to take photos. When a corresponding control key of the self-powered selfie stick is pressed, the self-resetting power generator is linked to generate electrical energy to supply power for the communication circuit, so that the communication circuit sends a photographing instruction to the mobile terminal device. When the control key is released, the self-resetting power generator automatically returns to the initial state for the next photographing operation.

In one embodiment, the self-resetting power generator includes a hollow coil, a magnetic suspension assembly and a housing. The magnetic suspension assembly includes a driving part and a return part, and at least one of the driving part and the return part is a permanent magnet. The driving part is linked to the control key. The housing includes a top cover, a bottom cover and a power generation cavity defined by the top cover and the bottom cover. The hollow coil is accommodated in the power generation cavity. The top cover has a driving hole communicating with the power generation cavity, and the hollow coil defines a hollow channel. In the state where the hollow coil is accommodated in the power generation cavity, the driving hole communicates with the hollow channel to form a magnetic suspension channel. The return part is arranged in the magnetic suspension channel, and is adsorbed to the top cover under magnetic attraction to be maintained at an initial position in the state where at least one of the driving part and the return part is a permanent magnet. The driving part extends into the magnetic suspension channel from the driving hole of the top cover, and drives the return part to move along the magnetic suspension channel when the corresponding control key is pressed, so as to form a change in the magnetic flux of the hollow coil to generate electrical energy. Corresponding to the return part being suspended in the magnetic suspension channel under the magnetic attraction effect with the top cover, the return part returns to the initial position when the force on the driving part is removed.

According to another aspect of the present invention, the present invention provides a power generation method for a self-resetting magnetic suspension power generator, which includes the following steps:
A. Initially, a return part is adsorbed and maintained at an initial position under the magnetic attraction effect with a top cover;
B. Apply a force to a driving part to drive the return part to move along a magnetic suspension channel, thereby forming a change in the magnetic flux of a hollow coil to generate electrical energy once, and the return part is suspended in the magnetic suspension channel under the magnetic attraction effect with the top cover;
C. When the return part moves to an end position, remove the force applied to the driving part, and the return part automatically returns to the initial position under the magnetic attraction effect with the top cover.

In one embodiment, in step (A), the return part is magnetically adsorbed to the inner side of the top cover and is centered at the center of the top cover.

In one embodiment, in step (A), one side of the return part is magnetically adsorbed to the inner side of the top cover, and the other side is empty, so that the return part is fixed in a magnetic suspension manner only by magnetic force without a fixed connection device.

In one embodiment, in step (A), a driving hole is arranged at the center of the top cover, and the driving hole is concentrically arranged with the return part.

In one embodiment, in step (B), the return part moves axially along the magnetic suspension channel.

In one embodiment, initially, the return part and the top cover are magnetically adsorbed together. When the applied force exceeds the magnetic adsorption force between the return part and the top cover, the driving part suddenly ejects the return part along the magnetic suspension channel, so that the hollow coil can generate an induction pulse instantaneously.

In one embodiment, in step (B), the movement stroke of the return part along the magnetic suspension channel is greater than or equal to 0.5 mm and less than or equal to 6 mm.

In one embodiment, in step (B), the movement speed of the return part is greater than 0.05 m/s.

In one embodiment, in step (C), the return part returns to the initial position to disturb the change in the magnetic flux of the hollow coil again to generate electrical energy for the second time.

According to another aspect of the present invention, the present invention provides a self-resetting magnetic suspension power generator, which includes:
- A hollow coil, wherein the hollow coil defines a hollow channel;
- A top cover, wherein the hollow coil is accommodated below the top cover, the top cover has a driving hole communicating with the hollow channel and a driving tube extending downward from the periphery of the driving hole, one end of the driving tube far away from the driving hole is the bottom end of the driving tube, and the hollow coil is arranged around the driving tube;
- A return part, wherein the return part is a permanent magnet, the return part is arranged below the top cover and is adsorbed to the bottom end of the driving tube under magnetic attraction to be maintained at an initial position, the return part moves axially relative to the hollow coil when driven by a force, and corresponding to the return part being suspended below the top cover under the magnetic attraction effect with the top cover, the return part automatically returns to the initial position when the force is removed.

In one embodiment, the length of the driving tube is set to be greater than or equal to 0.1 mm and less than or equal to 15 mm.

In one embodiment, the movement stroke of the return part is set to be greater than or equal to 0.5 mm and less than or equal to 6 mm.

In one embodiment, when the return part is driven, the side of the return part away from the driving hole protrudes from the side of the hollow coil away from the driving hole.

In one embodiment, the volume of the magnet of the return part is set to be greater than 25 cubic millimeters.

In one embodiment, the size of the return part is equal to the total surface area of the bottom of the driving tube.

In one embodiment, the number of turns of the hollow coil is set to be greater than 250 turns and less than 1500 turns.

In one embodiment, when the self-resetting magnetic suspension power generator is installed on a corresponding housing, the distance between the return part and the corresponding housing is greater than 0.1 mm.

In one embodiment, the top cover includes a first magnetic wall, and a second magnetic wall and a third magnetic wall extending downward from the first magnetic wall, and the center of the first magnetic wall is hollowed out to form the driving hole.

In one embodiment, the first magnetic wall has an inner side facing the driving hole and an outer side opposite to the inner side, the second magnetic wall extends downward from the outer side of the first magnetic wall, the third magnetic wall extends downward from the inner side of the first magnetic wall, and the hollow coil is accommodated between the second magnetic wall and the third magnetic wall.

In one embodiment, the hollow coil is arranged in a ring shape.

According to another aspect of the present invention, the present invention also provides a resetting method for a self-resetting magnetic suspension power generator, which includes the following steps:
a. Arrange a driving hole on a top cover, so that an external force can apply a pushing force to a return part through the driving hole;
b. Magnetically adsorb the return part and the top cover, so that the return part is freely magnetically adsorbed to the top cover. When the return part is pushed and the pushing force is greater than the magnetic attraction force between the return part and the top cover, the return part is clamped by the dual forces of the pushing force and the magnetic attraction force and moves away from the top cover in a suspended manner; when the pushing force is equal to the magnetic attraction force, the return part can stay stationary in a suspended manner;
c. Reduce or remove the pushing force, so that when the pushing force is less than the magnetic attraction force, the return part moves towards the top cover in a suspended manner and resets.

In one embodiment, in step (a), the return part abuts against the top cover and is arranged concentrically with the driving hole.

In one embodiment, a driving tube is further arranged between the return part and the driving hole, one side of the return part abuts against the driving tube, and the other side is arranged in a suspended manner.

In one embodiment, the periphery of the return part abuts against the periphery of the driving hole.

In one embodiment, in step (b), a pushing force is applied to the return part through a driving part. When the pushing force exceeds the magnetic adsorption force between the return part and the top cover, the driving part suddenly ejects the return part along a magnetic suspension channel, so that the return part has a high movement acceleration.

In one embodiment, in step (b), a hollow coil is arranged concentrically with the return part, so that when the return part moves away from the top cover in a suspended manner, the hollow coil is disturbed to generate an induction pulse instantaneously.

In one embodiment, in step (c), when the return part moves towards the top cover in a suspended manner and resets, the hollow coil is disturbed to generate an induction pulse again instantaneously.

According to another aspect of the present invention, the present invention also provides a magnetic suspension power generator, which includes a top cover, a return part and a hollow coil. The top cover has a driving hole, the return part abuts against the top cover initially, the hollow coil has a hollow channel. When an external force passes through the driving hole to drive the return part, the return part moves away from the driving tube along the hollow channel in a piston-like manner, thereby disturbing the hollow coil to generate an induction pulse once. The magnetic suspension power generator includes a driving tube, one end of the driving tube abuts against the driving hole, the other end of the driving tube abuts against the return part, and the hollow coil is arranged around the driving tube.

In one embodiment, when the external force is removed, the return part freely returns to an initial position under the action of magnetic force and abuts against the driving tube, and the hollow coil is disturbed to generate an induction pulse again during the resetting process of the return part.

In one embodiment, the driving hole, the driving tube, the return part and the hollow coil are arranged concentrically.

In one embodiment, one end of the driving tube abuts against the periphery of the driving hole, and the other end of the driving tube abuts against the periphery of the return part.

In one embodiment, the part of the return part except the position where it abuts against the driving tube is the driven part of the return part, the driving tube is hollow, and the corresponding external force passes through the driving tube to act on the driven part of the return part, thereby driving the return part to move.

In one embodiment, the magnetic suspension power generator includes a driving part, the driving part is movably arranged in a cavity formed by the driving hole and the driving tube. When an external force is applied, the driving part drives the return part to move away from the driving tube. When the external force is removed, the return part resets and pushes the driving part back to an initial position.

In one embodiment, initially, the return part is magnetically adsorbed to the driving tube. When the external force is greater than the magnetic adsorption force between the return part and the driving tube, the external force is converted into an instantaneous explosive ejection force applied to the return part to eject the return part away from the driving tube, so that a high induced electromotive force is generated in the hollow coil based on the high-speed ejection.

According to another aspect of the present invention, the present invention also provides a power generation method for a magnetic suspension power generator. The magnetic suspension power generator includes a top cover, a return part and a hollow coil. The top cover has a driving hole, the return part is magnetically adsorbed to the top cover, the hollow coil is sleeved on the outer periphery of the return part, and the center of the hollow coil has a hollow channel. The power generation method for the magnetic suspension power generator includes the following steps:
I. Apply an external force to drive the return part through the driving hole, and the external force is greater than the adsorption force between the return part and the top cover, thereby ejecting and driving the return part to separate from the top cover and move away from the top cover along the hollow channel, disturbing the hollow coil to generate an induced electromotive force once;
II. Remove the corresponding external force, and the return part moves towards the top cover under the action of the magnetic adsorption force with the top cover, so as to disturb the hollow coil to generate an induced electromotive force again.

In one embodiment, the return part is arranged concentrically with the driving hole.

In one embodiment, the return part moves in a piston-like manner along the hollow channel.

In one embodiment, in step (II), the return part moves towards the top cover and is re-adsorbed to the top cover.

In one embodiment, the top cover and the return part are arranged in a stacked manner and are adsorbed only by magnetic force.

In one embodiment, the periphery of the driving hole is arranged opposite to the periphery of the return part.

In one embodiment, when the return part is far away from the top cover, the return part can be maintained in a suspended state under the clamping of the dual forces of the external force and the magnetic attraction force; when the corresponding external force is removed, the return part automatically returns to the initial position from the end position under the magnetic attraction effect with the top cover.

According to another aspect of the present invention, the present invention also provides a non-blind area pressing driving device, which includes:
- A power generator;
- A movable shell, wherein the movable shell includes a panel, a second side edge and a central shaft, the second side edge extends downward from the panel, and the central shaft is arranged at the center of the panel; and
- A fixed shell, wherein the movable shell is movably arranged above the fixed shell, the power generator is accommodated between the movable shell and the fixed shell and abutted against by the central shaft to provide a balanced supporting force for the movable shell. When the movable shell is driven by an external force, the second side edge of the movable shell is pivotally connected to the fixed shell, and the power generator is driven by the movable shell to generate electrical energy.

In one embodiment, the power generator includes a hollow coil, a magnetic suspension assembly and a housing. The hollow coil defines a hollow channel, the magnetic suspension assembly includes a driving part and a return part, and at least one of the driving part and the return part is a permanent magnet. The housing includes a top cover, a bottom cover and a power generation cavity defined by the top cover and the bottom cover, the hollow coil is accommodated in the power generation cavity, the top cover has a driving hole communicating with the power generation cavity. In the state where the hollow coil is accommodated in the power generation cavity, the driving hole communicates with the hollow channel to form a magnetic suspension channel. The driving part extends into the magnetic suspension channel from the driving hole of the top cover, the return part is arranged in the magnetic suspension channel, and is adsorbed to the top cover under magnetic attraction to be maintained at an initial position in the state where at least one of the driving part and the return part is a permanent magnet. The driving part is abutted against by the central shaft, so that when the movable shell is driven by a force, it is driven by the central shaft to link and drive the return part to move along the magnetic suspension channel, so as to form a change in the magnetic flux of the hollow coil to generate electrical energy. Corresponding to the return part being suspended in the magnetic suspension channel under the magnetic attraction effect with the top cover, the return part returns to the initial position when the force on the movable shell is removed.

According to another aspect of the present invention, the present invention also provides a non-blind area pressing power generation method, which includes the following steps:
A. In a static state, a power generator provides a balanced supporting force to the middle position of a movable shell;
B. Press the movable shell, so that a second side edge at the edge of the movable shell is pivotally connected to a buckle of a fixed shell below the movable shell, thereby forming a driving state of non-blind area pressing on the surface of the movable shell to drive the power generator to generate electrical energy.

In one embodiment, in step (A), an energy storage part of the power generator supports a central shaft of the movable shell, so that the movable shell is maintained in a state of being balanced and supported by the power generator.

In one embodiment, in step (A), a return part of the power generator longitudinally provides a balanced supporting force to the middle position of the movable shell.

In one embodiment, the top of the side edge of the fixed shell has an upper end surface; the end of the first side edge of the movable shell is provided with a lower end surface, and the upper end surface and the lower end surface are arranged in a staggered manner.

In one embodiment, the second side edge is divided into at least 3 sections, and each section of the second side edge is provided with a hook matched with the buckle.

### Brief Description of the Drawings

Figure 1 is a schematic diagram of a power generation device in the prior art.
Figure 2 is a schematic diagram of the structural principle of the self-resetting magnetic suspension power generator according to the present invention.
Figure 3 is a structural schematic diagram of the self-resetting magnetic suspension power generator according to an embodiment of the present invention.
Figure 4 is an exploded structural schematic diagram of the self-resetting magnetic suspension power generator according to the above embodiment of the present invention.
Figure 5A is a schematic diagram of the self-resetting magnetic suspension power generator according to the above embodiment of the present invention in an initial state.
Figure 5B is a schematic diagram of the self-resetting magnetic suspension power generator according to the above embodiment of the present invention in an operated state.
Figure 6 is an exploded structural schematic diagram of the self-resetting magnetic suspension power generator according to a preferred embodiment of the present invention.
Figure 7 is a cross-sectional structural schematic diagram of the self-resetting magnetic suspension power generator according to the above preferred embodiment of the present invention.
Figure 8A is a schematic diagram of the self-resetting magnetic suspension power generator according to the above preferred embodiment of the present invention in an initial state.
Figure 8B is a schematic diagram of the self-resetting magnetic suspension power generator according to the above preferred embodiment of the present invention in an operated state.
Figure 9 is a structural schematic diagram of the self-resetting magnetic suspension power generator according to a second embodiment of the present invention.
Figure 10 is an exploded structural schematic diagram of the self-resetting magnetic suspension power generator according to the above second embodiment of the present invention.
Figure 11A is a schematic diagram of the self-resetting magnetic suspension power generator according to the above second embodiment of the present invention in an initial state.
Figure 11B is a schematic diagram of the self-resetting magnetic suspension power generator according to the above second embodiment of the present invention in an operated state.
Figures 12 to 14 are schematic diagrams showing the differences in the materials used for a magnetic suspension assembly of the self-resetting magnetic suspension power generator according to the above preferred embodiment of the present invention.
Figure 15 is a schematic diagram of the distribution of magnetic induction lines of the self-resetting magnetic suspension power generator according to the above preferred embodiment of the present invention.
Figure 16 is a structural schematic diagram of a modified embodiment of the self-resetting magnetic suspension power generator according to the above embodiment of the present invention.
Figure 17 is a structural schematic diagram of a modified embodiment of the self-resetting magnetic suspension power generator according to the above embodiment of the present invention.
Figure 18 is a structural schematic diagram of a modified embodiment of the self-resetting magnetic suspension power generator according to the above embodiment of the present invention.
Figure 19 is a structural schematic diagram of a self-resetting magnetic suspension power generator according to a third embodiment of the present invention.
Figure 20 is a structural schematic diagram of a self-resetting magnetic suspension power generator according to a fourth embodiment of the present invention.
Figure 21 is an exploded structural schematic diagram of a self-powered selfie stick including the self-resetting magnetic suspension power generator according to the above preferred embodiment of the present invention.
Figure 22 is an exploded structural schematic diagram of a non-blind area pressing driving device including the self-resetting magnetic suspension power generator according to the above preferred embodiment of the present invention.
Figure 23 is a partial enlarged view of Figure 22.

### Detailed Description of the Embodiments

The following description is used to disclose the present invention so that those skilled in the art can implement the present invention. The preferred embodiments in the following description are only examples, and those skilled in the art can think of other obvious variations. The basic principles of the present invention defined in the following description can be applied to other embodiments, modifications, improvements, equivalents and other technical solutions without departing from the spirit and scope of the present invention.

It should be understood by those skilled in the art that in the disclosure of the present invention, the terms such as "vertical", "horizontal", "upper", "lower", "front", "rear", "left", "right", "vertical", "horizontal", "top", "bottom", "inner" and "outer" indicate the orientation or positional relationship based on the orientation or positional relationship shown in the attached drawings, which are only for the convenience of describing the present invention and simplifying the description, rather than indicating or implying that the device or element referred to must have a specific orientation, be constructed and operated in a specific orientation. Therefore, the above terms should not be understood as limiting the present invention.

It can be understood that the term "one" should be understood as "at least one" or "one or more". That is, in one embodiment, the number of one element can be one, while in another embodiment, the number of the element can be multiple. The term "one" should not be understood as a limitation on the number.

In the description of the present invention, it should be noted that unless otherwise clearly specified and limited, the terms "installation", "connection" and "connection" should be understood in a broad sense. For example, it can be a fixed connection, a detachable connection or an integrated connection; it can be a mechanical connection, an electrical connection or a communication with each other; it can be a direct connection or an indirect connection through an intermediate medium; it can be the internal communication of two elements or the interaction relationship between two elements. For those of ordinary skill in the art, the specific meanings of the above terms in the present invention can be understood according to specific situations.

The present invention provides a self-resetting magnetic suspension power generator. The overall size of the self-resetting magnetic suspension power generator is close to the size of its hollow coil. Intuitively, the size of the self-resetting magnetic suspension power generator is less than that of a one-yuan coin, so that the self-resetting magnetic suspension power generator can be applied to many micro-devices, breaking the helpless situation that the existing micro-devices can only rely on battery power supply due to the size limitation of the generator. Moreover, the self-resetting magnetic suspension power generator has high power generation efficiency, and its power generation can meet the power demand of the corresponding devices.

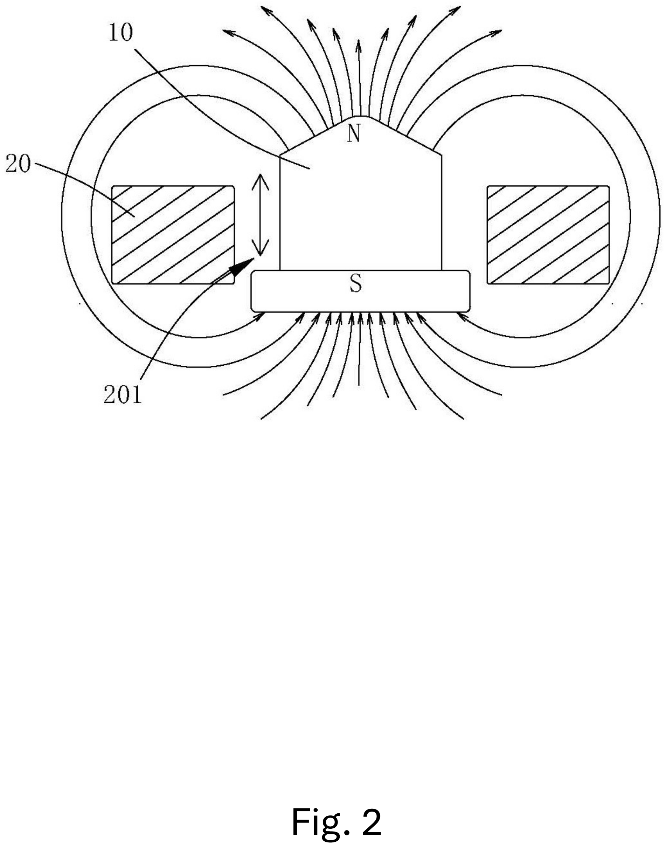

Specifically, referring to Figure 2, the structural principle of the self-resetting magnetic suspension power generator is schematically shown. The self-resetting magnetic suspension power generator 100 includes a magnetic suspension assembly 10 and a hollow coil 20. The hollow coil 20 defines a hollow channel 201. The magnetic suspension assembly 10 is arranged in the hollow channel 201 existing in the hollow coil 20 and moves axially relative to the hollow coil 20 along the hollow channel 201 to disturb the magnetic induction lines of the hollow coil 20, thereby generating induced electrical energy. The self-resetting magnetic suspension power generator 100 arranges the magnetic suspension assembly 10 by using the hollow channel 201 existing in the hollow coil 20. Therefore, the overall size of the self-resetting magnetic suspension power generator 100 is reduced to be close to the size of the hollow coil 20, overcoming the development bottleneck of miniaturization of the existing power generation devices and realizing the miniaturization of the self-resetting magnetic suspension power generator 100. At the same time, since the magnetic suspension assembly 10 moves axially relative to the hollow coil 20 along the hollow channel 201, the displacement within the range of the magnetic induction lines of the hollow coil 20 is larger, which improves the power generation efficiency of the self-resetting magnetic suspension power generator 100. Compared with the power generation efficiency of the existing pivotal movement type power generation devices, the power generation efficiency of the self-resetting magnetic suspension power generator 100 is improved by at least 20% to 35%, meeting the corresponding power supply demand.

In particular, when the magnetic suspension assembly 10 moves axially relative to the hollow coil 20 along the hollow channel 201, the magnetic field around the magnetic suspension assembly 10 will cover the hollow coil 20 in 360 degrees. Therefore, compared with the structure in the prior art that uses a magnetic conductive plate to conduct the magnetic field on one side or a certain direction of the magnet to act on the coil, the present invention has a higher utilization rate of the magnetic field, and improves the power generation efficiency while reducing the volume.

It is worth mentioning that the magnetic suspension assembly 10 of the self-resetting magnetic suspension power generator 100 has a small volume and can be automatically reset without using an additional reset device. Moreover, the magnetic suspension assembly 10 and the hollow coil 20 of the self-resetting magnetic suspension power generator 100 operate independently, and there is no need to set up an interconnection mechanism between them. The magnetic suspension assembly 10 is in a magnetic suspension structure in the hollow channel 201 of the hollow coil 20 only by using magnetic attraction. It can be understood that the terms "magnetic suspension", "suspension" and "magnetic levitation" in the present invention mean that the magnetic suspension assembly 10 can move axially relative to the hollow coil 20 in the hollow channel 201 of the hollow coil 20 to make the hollow coil 20 generate electrical energy, and the magnetic suspension assembly 10 can maintain the initial state in the hollow channel 201 of the hollow coil 20 and realize reset only by using magnetic attraction.

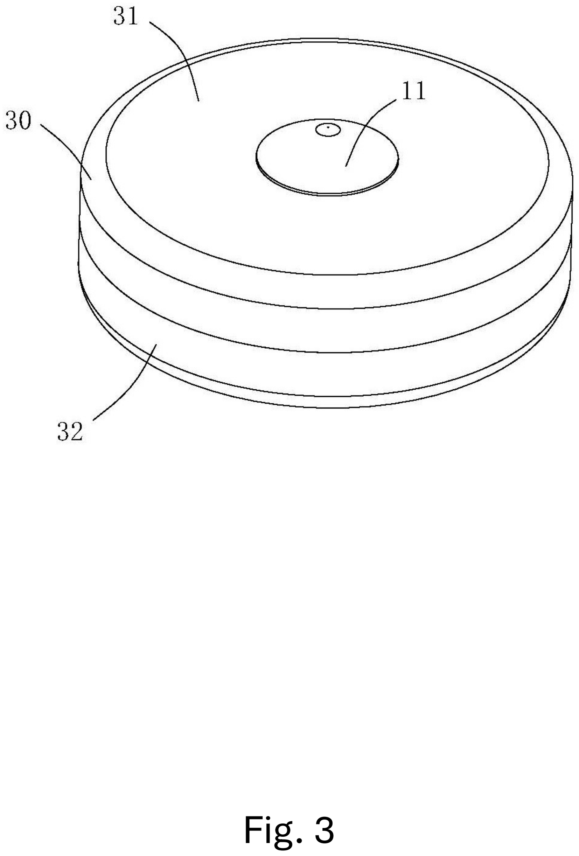

Referring to Figures 3 to 5B in detail, the specific structure of the self-resetting magnetic suspension power generator 100 according to an embodiment of the present invention is schematically shown. Specifically, the self-resetting magnetic suspension power generator 100 further includes a housing 30. The housing 30 has a top cover 31 and a power generation cavity 301 defined below the top cover 31. The magnetic suspension assembly 10 includes a driving part 11 and a return part 12. At least one of the driving part 11 and the return part 12 is a permanent magnet. The hollow coil 20 is accommodated in the power generation cavity 301. The top cover 31 has a driving hole 311 communicating with the power generation cavity 201. In the state where the hollow coil 20 is accommodated in the power generation cavity 301, the driving hole 311 communicates with the hollow channel 201 to form a magnetic suspension channel. The return part 12 is arranged in the magnetic suspension channel. Corresponding to the state where at least one of the driving part 11 and the return part 12 is a permanent magnet, the return part 12 and the top cover 31 have a magnetic attraction force and are adsorbed by the top cover 31 under the magnetic attraction effect, so as to be maintained at an initial position. The driving part 11 extends into the magnetic suspension channel from the driving hole 311 of the top cover 31, and drives the return part 12 to move away from the top cover 31 when pressed by a force, that is, the return part 12 is driven by the driving part 11 to move along the magnetic suspension channel to disturb the magnetic induction lines of the hollow coil 20 to form a change in magnetic flux and generate electrical energy. Corresponding to the return part 12 being suspended in the magnetic suspension channel under the magnetic attraction effect with the top cover 31, when the force on the driving part 11 is removed, the return part 12 returns to the initial position, thereby disturbing the magnetic induction lines of the hollow coil 20 again to form a change in magnetic flux and generate electrical energy again. In this way, the magnetic suspension assembly 10 moves back and forth in a suspended manner along the magnetic suspension channel, forming a change in magnetic flux and generating induced electrical energy.

In particular, the return part 12 is driven by applying a pushing force to the return part 12. When the pushing force is greater than the magnetic attraction force between the return part 12 and the top cover 31, the return part 12 is clamped by the dual forces of the pushing force and the magnetic attraction force and moves away from the top cover 31 in a suspended manner. That is to say, the magnetic attraction force between the return part 12 and the top cover 31 is a reset force, and the direction of the pushing force is exactly opposite to that of the reset force. Therefore, under the combination of these two forces, the return part 12 can be clamped in a suspended manner to maintain the suspended state of the return part 12, so that the return part 12 can move in a suspended manner at any time only by the interaction of the above two forces without any fixed connection, and will not fall off. When the pushing force is equal to the magnetic attraction force, the return part 12 can stay stationary in a suspended manner; when the pushing force is less than the magnetic attraction force, the return part 12 moves towards the top cover 31 in a suspended manner and resets. That is to say, when a force is applied to the return part 12, the force pushing the return part 12 and the magnetic force pushing the return part 12 to reset in the opposite direction act on the return part 12 together, so that the return part 12 can move in a suspended manner in the magnetic suspension channel only by the support and clamping of two interacting and opposite forces without being fixed by a fastening device, thereby forming a magnetic suspension movement state, a magnetic suspension working state or a suspension state of the return part 12. It should be emphasized that if the return part 12 does not realize the suspended movement capable of automatic reset under the interaction of the above two forces, but adopts the bistable movement mode in the prior art and needs to provide other reset forces to reset the return part 12, this mode does not belong to the suspended movement mode. In the present invention, even during the movement process, the return part 12 is in a suspended state and is clamped by two opposite acting forces. When an external force is used to drive the return part 12 away from the top cover, the reset pushing force of the return part 12, that is, the magnetic attraction force between the return part 12 and the top cover 31, can be felt all the time. When the external force is removed at any time, the return part 12 can be quickly reset automatically.

It is worth mentioning that when the return part 12 realizes the magnetic attraction reset of the magnetic suspension assembly 10, it also forms a change in magnetic flux to generate power, which can not only reset but also further generate power, so as to improve the power generation efficiency of the self-resetting magnetic suspension power generator 100.

Further, the housing 30 includes a bottom cover 32, and the power generation cavity 301 is defined by the top cover 31 and the bottom cover 32, that is, the power generation cavity 301 is formed between the top cover 31 and the bottom cover 32. The hollow coil 20 is accommodated between the top cover 31 and the bottom cover 32, and the return part 12 of the magnetic suspension assembly 10 moves in the power generation cavity 301 to disturb the magnetic induction lines to form a change in magnetic flux.

It is worth mentioning that the top cover 31 and the bottom cover 32 of the housing 30 wrap the hollow coil 20 accommodated in the power generation cavity 301, so that the hollow coil 20 is not easily damaged by external forces, thereby improving the reliability and durability of the self-resetting magnetic suspension power generator 100.

It should be pointed out that in the magnetic switching generator in the prior art, the mutual movement between the magnetic conductive plate of the magnet and the iron core of the coil will generate mechanical collision and produce "pa-pa" mechanical impact noise. Moreover, in the prior art, in order to improve the magnetic conductivity between the magnetic conductive plate and the iron core, these components are usually made of alloy materials, such as iron-nickel alloy, which leads to high manufacturing costs. In particular, in the present invention, since the self-resetting magnetic suspension power generator 100 adopts a magnetic suspension structure, there is no mechanical collision and friction between the top cover 31 and the bottom cover 32 of the housing 30 and various components, which will not cause accelerated oxidation of the magnetic conductive material. Therefore, the housing 30 can be made of ordinary galvanized iron plates, and the manufacturing cost can be reduced by 70%, which significantly reduces the manufacturing cost of the self-resetting magnetic suspension power generator 100. At the same time, the mechanical noise of the self-resetting magnetic suspension power generator 100 is lower than that of the generators in the prior art. That is to say, the self-resetting magnetic suspension power generator 100 provided by the present invention has neither the loud mechanical noise as in the prior art nor significantly reduced costs, resulting in very obvious economic benefits.

In particular, the magnetic suspension assembly 10 moves axially relative to the hollow coil 20 along the magnetic suspension channel to disturb the magnetic induction lines formed by the hollow coil 20 at the center of the hollow coil 20. The displacement within the range of the magnetic induction lines of the hollow coil 20 is larger, which improves the power generation efficiency of the self-resetting magnetic suspension power generator 100. Compared with the power generation efficiency of the existing pivotal movement type power generation devices, the power generation efficiency of the self-resetting magnetic suspension power generator 100 is improved by at least 20% to 35%, thereby improving the power generation efficiency of the self-resetting magnetic suspension power generator 100.

That is to say, the relative movement direction of the magnetic suspension assembly 10 and the hollow coil 20 is an axial movement along the magnetic suspension channel, which is different from the pivotal movement mode of the existing power generation devices, thereby improving the disturbance of the magnetic suspension assembly 10 to the magnetic induction lines, increasing the change in magnetic flux, and improving the power generation efficiency of the self-resetting magnetic suspension power generator 100.

It should be pointed out that the self-resetting magnetic suspension power generator 100 disclosed in the present application provides a high-efficiency generator technical solution. Optionally, in some embodiments, for application scenarios where some loads are ultra-low-power RF chips, on the premise of ensuring that the generated electrical energy meets the needs, part of the top cover 31 and the bottom cover 32 of the housing 30 can be cut off as needed to meet the needs of wire leads or adapt to the overall assembly needs, for example, additional holes are opened on the top cover 31 and the bottom cover 32, or the side edges or both sides of the top cover 31 and the bottom cover 32 are partially cut off.

Further, the top cover 31 includes a first magnetic wall 3101, and a second magnetic wall 3102 extending downward from the first magnetic wall 3101 and perpendicular to the first magnetic wall 3101. The center of the first magnetic wall 3101 is hollowed out to form the driving hole 311. Corresponding to the first magnetic wall 3101, it has an inner side facing the driving hole 311 and an outer side opposite to the inner side. The second magnetic wall 3102 extends downward from the outer side of the first magnetic wall 3101, so that the power generation cavity 301 can be defined below the top cover 31 based on the shape design of the top cover 31. The bottom cover 32 includes a bottom magnetic wall 3201 and a side magnetic wall 3202 extending upward from the edge of the bottom magnetic wall 3201 and perpendicular to the bottom magnetic wall 3201. The second magnetic wall 3102 of the top cover 31 and the side magnetic wall 3202 of the bottom cover 32 are directly abutted against or close to each other to enhance the intensity of the magnetic induction lines covering the hollow coil 20, which is beneficial to improving the power generation efficiency of the self-resetting magnetic suspension power generator 100.

It is worth mentioning that the second magnetic wall 3102 of the top cover 31 has the function of magnetic gathering, which can reduce the magnetic resistance between the N-S poles of the return part 12, that is, reduce the width of the open magnetic field between the N-S poles, so that the magnetic field density between the N-S poles of the return part 12 is significantly enhanced to enhance the utilization rate of the magnetic field, thereby improving the power generation efficiency. If the second magnetic wall 3102 is not provided, the efficiency of the self-resetting magnetic suspension power generator 100 will decrease by more than 50%, and it cannot provide effective driving power, so it has no practicality. It can be understood that the self-resetting magnetic suspension power generator 100 disclosed in the present invention is a micro-generator, and various components need to be precisely matched. Therefore, the shape of each component, the abutment relationship and the width of the magnetic gap will affect the efficiency of the self-resetting magnetic suspension power generator 100.

In addition, the arrangement of the second magnetic wall 3102 also enables the self-resetting magnetic suspension power generator 100 to be installed and fixed on specific products. For example, holes or grooves are arranged on the second magnetic wall 3102, and the self-resetting magnetic suspension power generator 100 can be stabilized by hooking the grooves on the second magnetic wall 3102 with the hooks on the housing. It is also worth mentioning that the arrangement of the second magnetic wall 3102 can also protect the hollow coil 20 from being damaged during the transportation and installation of the self-resetting magnetic suspension power generator 100.

It is worth mentioning that in this embodiment of the present invention, the top cover 31 and the bottom cover 32 of the housing 30 are in an up-down distributed structure. Based on the realization of the same purpose, in some embodiments, the housing 30 can also be designed as a left-right distributed housing structure, such as setting the housing 30 as two semicircles and assembling them left and right to form the housing 30. Corresponding to the state where the left and right housings are combined, the left and right housings jointly define the power generation cavity 301, and the upper parts of the left and right housings correspond to the top cover 31, and the lower parts correspond to the bottom cover 32. The effect is the same as that of the up-down distributed structure of the housing 30 exemplified in the present invention, which belongs to a modified implementation structure of the housing 30, and the present invention does not limit this.

It is worth mentioning that the magnetic suspension assembly 10 is arranged by using the hollow channel 201 defined by the hollow coil 20, so as to make full use of the existing size of the self-resetting magnetic suspension power generator 100, so that the overall size of the self-resetting magnetic suspension power generator 100 can be set to be close to the size of the hollow coil 201. Intuitively, the size of the self-resetting magnetic suspension power generator 100 is less than that of a one-yuan coin, and the miniaturization of the self-resetting magnetic suspension power generator 100 is realized.

In particular, the magnetic suspension assembly 10 moves along the magnetic suspension channel when driven, and can reset automatically and move along the magnetic suspension channel in the direction opposite to the direction when driven, so as to move back and forth in the magnetic suspension channel. There is no need to set up a large and complex pivotal movement assembly and reset assembly, thereby realizing the miniaturization of the self-resetting magnetic suspension power generator 100.

It is worth mentioning that the magnetic suspension assembly 10 and the hollow coil 20 are independent of each other, and there is no need to set up additional connecting components. That is to say, the magnetic suspension assembly 10 is arranged in a suspended manner relative to the hollow coil 20, and moves relative to the hollow coil 20 along the magnetic suspension channel in a suspended state, simplifying the structural design of the self-resetting magnetic suspension power generator 100.

In other words, the magnetic suspension assembly 10 moves in a suspended manner in the magnetic suspension channel, and there is no need to set up complex pivotal movement components, reset components and connecting components. The self-resetting magnetic suspension power generator 100 has a simple structure, high modularity and integrity of components, reduced production difficulty and process precision requirements, which is conducive to reducing the volume of the self-resetting magnetic suspension power generator 100, and at the same time reducing the production and manufacturing cost of the self-resetting magnetic suspension power generator 100 and improving the production yield of the self-resetting magnetic suspension power generator 100.

Further, the movement stroke of the magnetic suspension assembly 10 enables the return part 12 to maintain a magnetic attraction force with the top cover 31 and automatically reset after the force on the driving part 11 is removed, thereby realizing the self-resetting of the self-resetting magnetic suspension power generator 100 without setting a dedicated reset device, simplifying the structural design of the self-resetting magnetic suspension power generator 100 and ensuring the performance of the self-resetting magnetic suspension power generator 100.

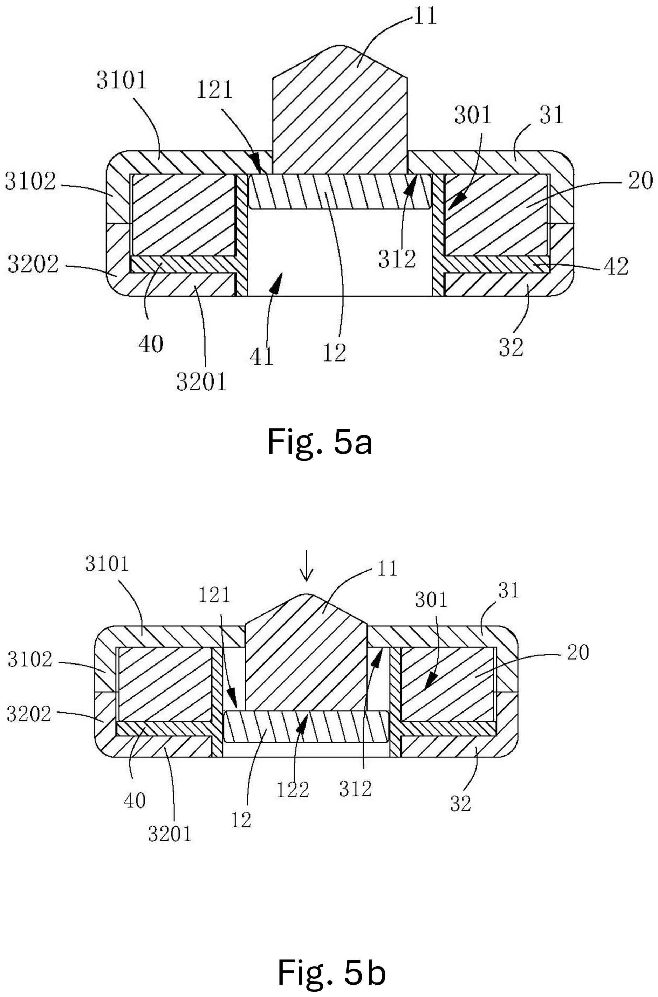

For further reference to Figures 5A and 5B, the return part 12 has an abutting part 121. Initially, the abutting part 121 of the return part 12 is adsorbed and abutted against a contact part 312 on the top cover 31 under the action of magnetic attraction. The contact part 312 is located on the first magnetic wall 3101 and surrounds the inner side of the first magnetic wall 3101. When the return part 12 is implemented as a permanent magnet, it provides a stable N-pole magnetic field to the top cover 31 of the housing 3. Under the diffusion and magnetic conduction effect of the first magnetic wall 3101 and the second magnetic wall 3102 of the upper cover 31, the magnetic induction lines are uniformly conducted to the bottom cover 32. The side magnetic wall 3202 and the bottom magnetic wall 3201 of the bottom cover 32 then conduct the magnetic induction lines to the S-pole of the return part 12, thereby forming a closed and stable magnetic field that completely covers the hollow coil 20. Based on this structure of the self-resetting suspended magnetic generator 100, the self-resetting suspended magnetic generator 100 has a high utilization rate of the magnetic field, so that the volume of the self-resetting suspended magnetic generator 100 can be made as small as possible, or it can generate higher electrical power than the generators in the prior art under the same volume. Moreover, when the return part 12 is pushed by the driving part 11, although the return part 12 moves at a relatively high speed, since the return part 12 will not collide with other components, it will not generate the huge "pop" noise in the prior art.

In particular, the return part 12 also has a driven part 122, which is the part of the return part 12 that is in contact with or close to the driving part 11. When the end 111 of the driving part 11 close to the return part 12 is attached to the driven part 122 of the return part 12, due to the large relative range between the driving part 11 and the return part 12, when the driving part 11 moves, it can have the beneficial effect of stabilizing and balancing the return part 12. The return part 12 will not shake during the process of being pushed forward or reset by the driving part 11. At the same time, due to the large relative range between the driving part 11 and the return part 12, when the return part 12 suddenly separates from the contact part 312 of the top cover 31 at the initial position, the abutting part 121 of the return part 12 is synchronously separated from the contact part 312 instantaneously at the micro level as a whole, which plays a crucial role in the intensity of the generated electrical energy. The reason is that the abutting part 121 is distributed around the driven part 122. When the return part 12 is driven by the driving part 11, if the abutting part 121 of the return part 12 and the contact part 312 of the top cover 31 are separated unbalancedly (one side is separated first and the other side is separated later), the above-mentioned effect of instantaneous synchronous separation cannot be achieved, and the instantaneous change of the magnetic field will be relatively slow, resulting in a significant reduction in the intensity of the generated electrical energy.

It is worth mentioning that initially, based on the magnetic attraction effect between the return part 12 and the top cover 31, the abutting part 121 of the return part 12 is adsorbed and in contact with the contact part 312 of the top cover 31. At this time, the top cover 31 is in a state of saturated magnetic field, and the hollow coil 20 is in a static saturated magnetic field. When the driving part 11 is driven by an external force, the driving part 11 pushes the return part 12 to move, and the return part 12 suddenly separates from the adsorption contact with the contact part 312 on the top cover 31 from the initial state. The top cover 31 is instantly changed from a saturated magnetic field to an unsaturated magnetic field, so the magnetic induction lines change in strength. Based on the change in strength of the magnetic field, the hollow coil 20 is disturbed by the dynamically changing magnetic field, causing a change in the density of the magnetic induction lines in the hollow coil 20, thereby making the hollow coil 20 generate induced electrical energy.

In particular, since the area of the side of the return part 12 facing the contact part 312 is larger than the relative area between the side of the return part 12 and the top cover 31, and the abutting part 121 of the return part 12 is arranged opposite to the contact part 312 of the top cover 31, the magnetic attraction between the abutting part 121 of the return part 12 and the top cover 31 is always greater than the magnetic attraction between other parts of the return part 12 and the top cover 31. That is, the abutting part 121 of the return part 12 and the top cover 31 have a strong magnetic interaction force. Even if the distance between them exceeds 2 mm, they can be automatically adsorbed together again under the condition of external force contact rotation, solving the technical defect in the prior art that reliable reset cannot be achieved when the distance exceeds 0.5 mm. Moreover, in some embodiments or application scenarios, even if the self-resetting suspended magnetic generator 100 is equipped with housing buttons, the self-resetting suspended magnetic generator 100 can still push the housing buttons to reset.

It is worth mentioning that in this embodiment of the present invention, the bottom cover 32 has a bottom opening 321 communicating with the power generation cavity 301, and the projection of the driving hole 311 towards the bottom cover 31 is preferably arranged in the bottom opening 321. In other words, the bottom opening 321 communicates with the hollow channel 201 defined by the hollow coil 20 and is larger than the driving hole 311, so as to ensure that the return part 12 maintains magnetic attraction with the top cover 31.

In particular, the aperture of the bottom opening 321 is larger than the outer diameter of the return part 12; this ensures that the strong magnetic induction lines on the magnetized surface of the return part 12 have less interaction with the bottom opening 321, and the return part 12 will not be adsorbed to the bottom cover 32 when moving. When the return part 12 moves to the bottom opening 321, it can also pass through the bottom opening 321, so that a first magnetic gap 302 is formed between the return part 12 and the bottom opening 321. It is precisely because of the existence of the first magnetic gap 302 that the magnetic induction density in the hollow coil 20 is greatly enhanced; the return part 12 is further pushed until the abutting part 121 of the return part 12 is close to the bottom cover 32. At this time, the magnetic field is reversed, that is, the N-pole of the return part 12, which was originally abutted against the driving hole 311, suddenly interacts with the bottom cover 32. The direction of the magnetic field passing through the hollow coil 20 is reversed. This complete change of the magnetic pole causes the magnetic density in the hollow coil 20 to be reversed instantaneously, thereby inducing strong energy.

In particular, in the prior art, when a magnet moves in a hollow coil, the magnetic induction lines only cut the coil vertically with a fixed magnetic pole without producing the special effect of instantaneous reversal of the magnetic pole. Without rotating the magnet, the magnetic pole of the magnet will not be reversed; moreover, the prior art needs to repeatedly move the magnet back and forth in the hollow coil for a period of time to accumulate energy for a period of time before it can be used. However, the technical solution disclosed in the present invention uses the electrical energy generated by a single operation for immediate use; for example, when the self-resetting suspended magnetic generator 100 supplies power to a wireless switch, the transmitting circuit can immediately send a signal at the moment of pressing, without waiting for accumulating enough energy through repeated operations as in the prior art; therefore, the power generated by the self-resetting suspended magnetic generator 100 will
increase by at least one time or even dozens of times compared with the prior art.

When the return part 12 is driven by the driving part 11 to the set position, a first magnetic gap 302 exists between the return part 12 and the bottom magnetic wall 3201 of the bottom cover 32 to ensure that the return part 12 will not be adsorbed to the bottom cover 32 and thus cannot be automatically reset. In this way, when the corresponding driving force is removed, the return part 12 can be reset to the initial position by itself. The first magnetic gap 302 is set to be less than 4 mm, which is beneficial to ensuring the power generation efficiency of the self-resetting suspended magnetic generator 100.

It can be understood that when the movement stroke of the suspended magnetic component 10 is such that the return part 12 can maintain magnetic attraction with the top cover 31, the bottom opening 321 can also be set to be smaller than the driving hole 311.

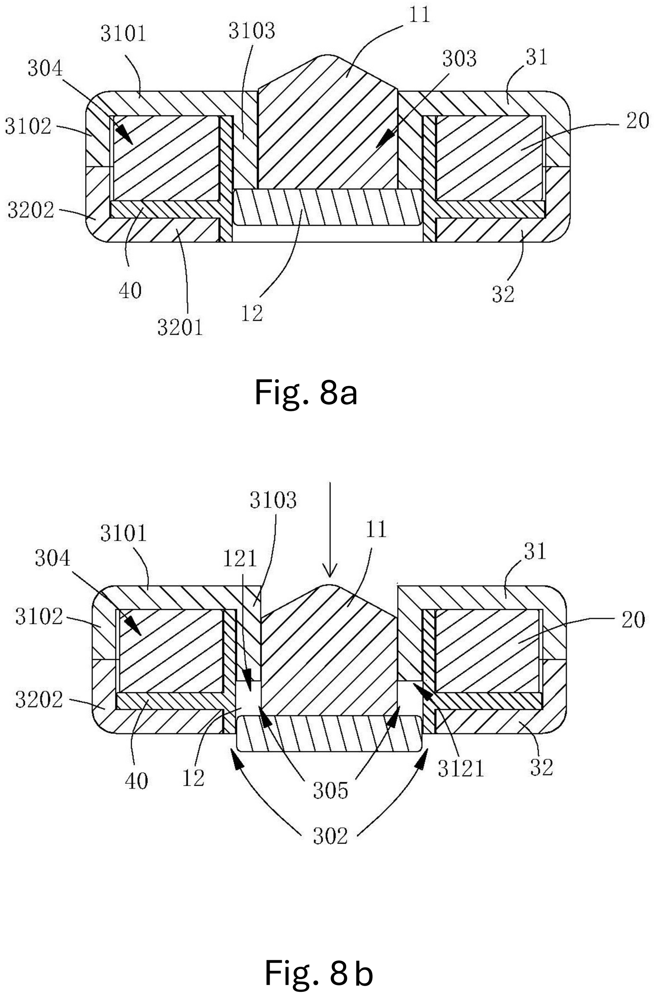

As shown in Figure 8B, since the magnetized surface of the return part 12 has the abutting part 121, and the abutting part 121 is arranged opposite to the driving tube 312, there is a strong magnetic attraction between them, which provides a prerequisite for long-distance magnetic attraction reset. The side surface of the return part 12 is not a magnetized surface, and there is a gap 302 between the return part 12 and the bottom cover 32, so the magnetic attraction is weak. Therefore, the return part 12 can pass through the bottom opening 321 on the bottom cover 32 without being adsorbed to the bottom cover 32. In this way, the stroke of the return part 12 can be further extended to enhance the power generation power, and at the same time, the return part 12 can have a long stroke and a strong automatic reset capability.

It should be particularly pointed out that when the return part 12 is driven by the driving part 11 to the end position, if the pressing drive state is maintained, the return part 12 is pressed by the driving part 11 and can stay suspended at the end position.

It should be particularly pointed out that the bottom opening 321 is not used for applying force to drive, and it has the following beneficial effects: first, it avoids the return part 12, so that the return part 12 can pass through the bottom opening 321 and has a large stroke to generate greater power generation power; second, the bottom opening 321 maintains the function of gathering the magnetic field, so that the N-S magnetic field of the return part 12 is closed and magnetically conducted by the top cover 31 and the bottom cover 32 in a closed manner, with extremely small magnetic resistance to improve power generation efficiency; third, it maintains an appropriate small distance between the return part 12 and the bottom opening 321 to form a state where the magnetic attraction between the driving hole 311 and the return part 12 is greater than that between the bottom opening 321 and the return part 12, ensuring the success of automatic reset; fourth, it prevents the return part 12 from colliding with the bottom cover 32 when moving at high speed, thus avoiding impact noise. As is known to all, magnets are fragile components, and repeated strong impacts will cause them to break. Therefore, the arrangement of the bottom opening 321 on the bottom cover 32 has significant beneficial effects.

In some embodiments, the bottom opening 321 may not be provided, but a proper distance must be maintained between the return part 12 and the bottom cover 32 to ensure that the return part 12 can be automatically reset, and the present invention does not limit this.

It is worth mentioning that since the discovery of the electromagnetic induction phenomenon more than 100 years ago, those skilled in the art have known that as long as a magnetic field cuts a closed coil, an induced electromotive force will be generated in the coil. However, this is only the theoretical basis. How to break through the limitations of the prior art, make the pressing of the micro-generator more labor-saving and the volume smaller, while still generating high-power electrical energy to drive the transmitting circuit to work, and having practical performance to achieve good economic benefits has been the goal of continuous research and development by those skilled in the art for many years.

It is worth mentioning that for the purpose of ensuring the structural stability of the self-resetting suspended magnetic generator 100, the self-resetting suspended magnetic generator 100 further includes a coil bracket 40. The coil bracket 40 is used to fix the shape of the hollow coil 20 and prevent the hollow coil 20 from being directly impacted by the suspended magnetic component 10. Specifically, the shape of the coil bracket 40 matches the shape of the hollow coil 20, and includes a bracket wall surrounding the hollow channel 201 of the hollow coil 20 and a bracket base 42 matching at least one side of the hollow coil 20. Thus, when the hollow coil 20 is installed on the coil bracket 40, the inner side wall of the hollow coil 20 is surrounded by the bracket wall of the coil bracket 40 to form a pipe 41, and at least one side of the hollow coil 20 is supported by the bracket base 42 of the coil bracket 40, so as to fix the shape of the hollow coil 20. In the state where the suspended magnetic component 10 moves along the hollow channel 201 of the hollow coil 20, i.e., moves along the pipe 41, the bracket wall between the suspended magnetic component 10 and the hollow coil 20 protects the hollow coil 20, preventing the suspended magnetic component 10 from colliding with the hollow coil 20, so as to extend the service life of the self-resetting suspended magnetic generator 100. In addition, the pipe 41 formed by the bracket wall makes the suspended magnetic component 10 move more smoothly and stably when performing axial piston-like movement relative to the hollow coil 20 in the hollow channel 201, and also protects the inner side of the hollow coil 20 from being easily damaged. In particular, due to the arrangement of the pipe 401, when the return part 12 is thin, the return part 12 will not roll over due to the limitation of the side wall of the pipe 41. Further, the bracket base 42 of the coil bracket 40 not only supports the hollow coil 20 but also plays a role in clamping the bottom cover 32. In other words, the coil bracket 40 not only has the function of supporting and fixing the hollow coil 20 but also plays a role in stably connecting multiple components of the self-resetting suspended magnetic generator 100, which is beneficial to reducing the assembly difficulty of the self-resetting suspended magnetic generator 100 and thus improving the production efficiency of the self-resetting suspended magnetic generator 100.

In particular, in some embodiments, the coil bracket 40 may be configured to close the opening of the hollow channel 201 close to the bottom cover 32 to form a movement limit for the suspended magnetic component 10, ensuring that the return part 12 maintains magnetic attraction with the top cover 31, so that the suspended magnetic component 10 moves in a suspended manner in the suspended magnetic channel.

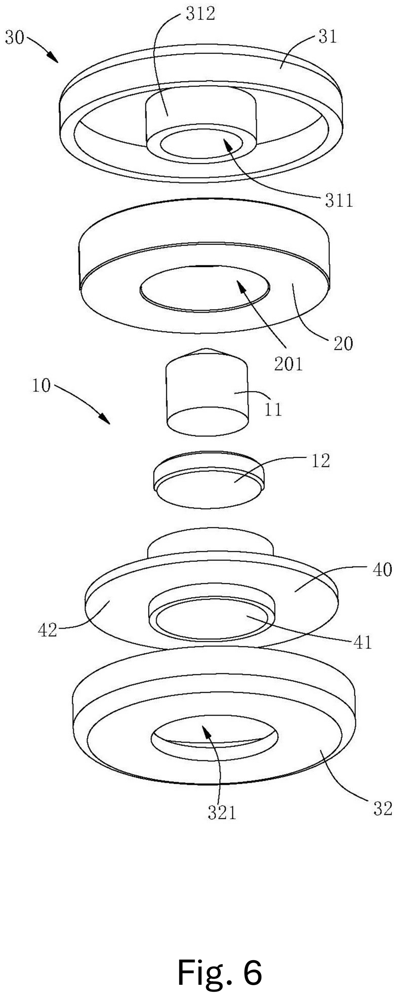

Further, in order to further improve the power generation efficiency and structural stability of the self-resetting suspended magnetic generator 100, the present invention further optimizes the structure of the self-resetting suspended magnetic generator 100. For specific reference to Figures 6 and 8B in the drawings of the specification of the present invention, a self-resetting suspended magnetic generator 100 according to a preferred embodiment of the present invention is illustrated. Specifically, in the preferred embodiment, the top cover 31 further includes a driving tube 312 extending from the periphery of the driving hole 311 towards the bottom cover 32. One end of the driving tube 312 where the driving hole 311 is located is the top end of the driving tube 312, and the other end of the driving tube 312 is the bottom end of the driving tube 312. The driving part 11 extends into the driving tube 312 from the top end of the driving tube 312, and drives the return part 12 located at the bottom end of the driving tube 312 to move away from the top cover 31 when being forced to drive. When the force applied to the driving part 11 is removed, the return part 12 is attracted to the top cover 31 under the magnetic attraction effect and moves towards the top cover 31, thereby being abutted against the bottom end of the driving tube 312. In this way, the driving tube 312 is used to guide and limit the movement of the suspended magnetic component 10, ensuring the structural stability of the self-resetting suspended magnetic generator 100.

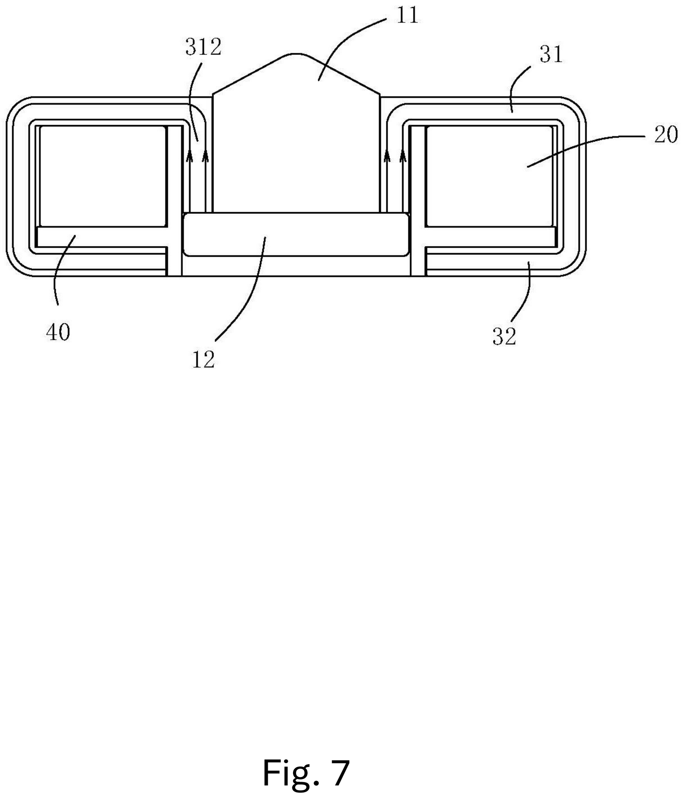

For further detailed reference to Figure 7, the driving tube 312 is located in the suspended magnetic channel, thereby forming a solid medium guide for the magnetic circuit in the suspended magnetic channel and improving the power generation efficiency of the self-resetting suspended magnetic generator 100. That is, in the state where the driving tube 312 is not provided, the magnetic circuit of the self-resetting suspended magnetic generator 100 is formed under the action of the two poles without a corresponding medium guide. In other words, the arrangement of the driving tube 312 achieves two purposes: it limits and guides the movement of the suspended magnetic component 10, and at the same time, it is equivalent to arranging a medium in the suspended magnetic channel to guide the magnetic circuit, which not only ensures the structural stability of the self-resetting suspended magnetic generator 100 but also improves the power generation efficiency of the self-resetting suspended magnetic generator 100.

It is worth mentioning that the driving tube 312 is inserted through the hollow coil 20 and located in the suspended magnetic channel. Therefore, the driving tube 312 increases the inductance of the hollow coil 20 to further enhance the magnetic flux BL value between the magnetic field and the hollow coil 20, so that the magnetic strength of the magnetic field acting on the hollow coil 20 is significantly increased, thereby improving the power generation efficiency of the self-resetting suspended magnetic generator 100. This enables the self-resetting suspended magnetic generator 100 to have a higher power generation efficiency after being miniaturized compared with the existing generators, and thus has a strong power generation capacity after being miniaturized. Therefore, the driving tube 312 has multiple beneficial effects: improving the magnetic field strength to enhance the power generation efficiency, forming a solid medium guide and positioning for the magnetic circuit, forming a solid medium movement limit and guide for the suspended magnetic component 10, and attracting and resetting the suspended magnetic component 10.

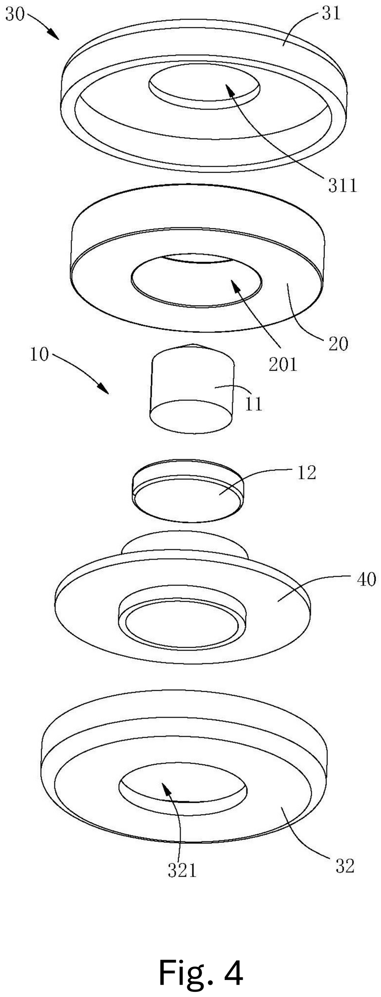

In particular, compared with the technical solution in Figure 4, this embodiment not only adds the driving tube 312 but also is an integral structure. Compared with the solution in Figure 4, the efficiency can be improved by more than 80%; the driving tube 312 is inserted into the hollow coil 20, which not only plays a role in clamping and stabilizing the hollow coil 20 but also further greatly increases the strength of the magnetic field passing through the hollow coil 20. Compared with the prior art where only a magnet passes through the hollow coil 20, the utilization rate of the magnetic field is higher; if only the magnet itself passes through the hollow coil 20 without the driving tube 312, the N-S pole magnetic induction lines will directly cause magnetic short circuit along the side of the magnet at the upper and lower ends of the magnet, so the number of magnetic induction lines passing through the hollow coil 20 will be reduced. The arrangement of the driving tube 312 is an important means to significantly improve the power generation efficiency of this embodiment. Through actual measurement, when the driving part 11 drives the return part to move 2.3 mm, this embodiment can generate 340 uJ of energy. That is, when the dummy load is 200 ohms, this embodiment can provide a 2V power supply voltage for the dummy load after voltage stabilization, and the duration can be as long as 17 mS, which meets the requirement of sending more than 20 frames of the Bluetooth short message protocol. If the energy generated during the automatic reset of this embodiment is further utilized, various low-power wireless communication devices can be driven during a cycle of pressing and releasing. Therefore, this embodiment has significant practical value and can be widely used in various passive products.

It is worth mentioning that in order to ensure that the return part 12 remains stable during the axial movement and prevent the return part 12 from deviating during the movement, in some embodiments, it is allowed to arrange a pipe 41 with a smooth inner wall in the suspended magnetic channel 201. A gap of more than 0.02 mm is maintained between the pipe 41 and the return part to ensure that the return part 12 can slide freely in the axial direction and can be kept centered by the pipe 41; initially, the return part 12 and the driving tube 312 are freely magnetically adsorbed together without being stabilized by other mechanical components. When an external force is applied to the return part 12, and the external force is greater than the magnetic attraction between the return part 12 and the driving tube 312, the return part 12 and the driving tube 312 are separated instantaneously; the return part 12 is ejected by the external force at a speed of about 0.05 m/S and can move freely and rapidly in the pipe 41 away from the driving tube 312, so that the hollow coil 20 surrounding the driving tube 312 generates induced electrical energy; when the return part 12 moves rapidly, it is guided by the pipe 41. Since the movement speed of the return part 12 is relatively high and the inner side of the pipe 41 is relatively smooth, the return part 12 can move freely at high speed with a small self-mass without being bound by mechanical components to generate as strong induced energy as possible, so as to improve the power generation efficiency of the self-resetting suspended magnetic generator 100.

It can be understood that the hollow coil 20 can be arranged either around the driving tube 312 or around the return part 12, which depends on the winding thickness of the hollow coil 20 and can be set according to the specific structure of the hollow coil 20.

It can be understood that the suspended magnetic channel is a space for the movement of the return part 12. The arrangement of the pipe 41 will make the movement of the return part 12 smoother and more stable. In some embodiments, when the side wall of the suspended magnetic channel is manufactured to be smooth or wear-resistant enough, the pipe may not be provided separately. In this way, only the inner wall of the hollow coil 20 can also serve as the pipe 41. The pipe 41 can also be formed by stacking multiple parts with holes in the middle. According to the disclosure of the present invention, as long as the movement of the return part 12 can be made smoother and more stable, the specific form and material of the pipe 41 are not limited by the present invention. In particular, one end of the pipe 41 is close to or abutted against the driving tube 312, and the other end extends away from the driving tube 312 to meet the requirement of the movement stroke of the return part 12; when a housing exists, the end of the pipe 41 away from the driving tube 312 is set to be close to or abutted against the housing.

It is worth mentioning that the return part 12 moves like a piston. In order to reduce the damping effect of air on the movement of the return part 12, the end of the pipe 41 away from the driving tube 312 is set to be open or has a small hole to prevent air from being compressed and generating damping characteristics.

In particular, the pipe 41 can be separately set to be O-shaped or C-shaped, for example, wound with a high-strength Teflon film sheet with a thickness of 0.15 mm, or integrally formed with the coil bracket 40, and the present invention does not limit this.

It is worth mentioning that different from the magnet design method in the prior art, the return part 12 of the present invention is a free suspended magnetic structure without a fixed connection method. That is, the return part 12 can be adsorbed and fixed by using the magnetic force between the return part 12 and the top cover 31 without the help of various fastening components such as screws, rivets, and fixing grooves, so as to move in the suspended magnetic channel in a free manner. In this way, a relatively high movement speed can be obtained with a small mass, so that the self-resetting suspended magnetic generator 100 generates high induced energy.

In particular, referring to Figures 8A and 8B, the bottom end of the driving tube 312 has a bottom end surface 3121. Initially, the bottom end surface 3121 is magnetically adsorbed by the return part 12, and the bottom end surface 3121 and the abutting part 121 of the return part 12 are adsorbed together under the action of magnetic force. Therefore, even when the return part 12 is driven away from the driving tube 312, since the abutting part 121 of the return part 12 is arranged opposite to the bottom end surface 3121, there is a large relative area between them, resulting in a strong magnetic interaction. Even if the distance between them exceeds 2 mm, they can be automatically adsorbed again under the condition of external force contact to realize the automatic reset of the return part 12. This solves the technical defect in the prior art that reliable reset cannot be achieved when the distance exceeds 0.5 mm, so that the self-resetting suspended magnetic generator 100 has a strong product manufacturing advantage when used as a passive wireless switch, which can reduce the number of parts, reduce the cost, have a simpler structure, and significantly improve the economic benefits.

It is worth mentioning that the driving tube 312 extends towards the bottom cover 32 and divides the power generation cavity 301 into a driving cavity 303 and an accommodating cavity 304. The driving cavity 303 accommodates the suspended magnetic component 10 and allows the suspended magnetic component 10 to move in the driving cavity 303. The accommodating cavity 304 accommodates the hollow coil 20. The driving cavity 303 and the accommodating cavity 304 have different functions and partitions and are relatively independent of each other.

Preferably, the length of the driving tube 312 is set to be greater than or equal to 0.1 mm and less than or equal to 15 mm, so as to meet the driving stroke of the suspended magnetic component 10 and ensure that the self-resetting suspended magnetic generator 100 is thin and light.

Further, when an external force drives the driving part 11, the driving part 11 transmits the force to the return part 12. Since the gap between the outer peripheral wall of the driving part 11 and the inner wall of the driving hole 311 is set to be very small, preferably less than 0.2 mm in the present invention, when the driving part 11 performs axial piston movement along the suspended magnetic channel, it can be limited by the driving hole 311 to maintain stability and will not topple during the movement. Further, when the driving part 11 drives the return part 12, the return part 12 pushed by the driving part 11 will also maintain stability. That is, the driving part 11 has the function of keeping the return part 12 moving stably.

In particular, when the return part 12 is driven by the driving part 11, the return part 12 is forced to move away from the driving tube 312. At this time, the return part 12 is separated from the driving tube 312. In the state where the return part 12 is separated from the driving tube 312, a second magnetic gap 305 is maintained between the return part 12 and the bottom end of the driving tube 312, and the magnetic field between the return part 12 and the driving tube 312 changes from a saturated magnetic field to an unsaturated magnetic field. Further, due to the driving of the driving part 11, the return part 12 will move to a position close to the bottom magnetic wall 3201, and the first magnetic gap 302 exists between the return part 12 and the bottom magnetic wall 3201. At this time, the magnetic field strength between the return part 12 and the bottom magnetic wall 3201 is significantly higher than that when the return part 12 is at the initial position. That is, the movement of the return part 12 causes a change in the magnetic density in the stable magnetic field in the initial state, thereby generating induced electrical energy in the hollow coil 20. The faster the movement speed of the return part 12, the higher the induced voltage generated in the hollow coil 20. In order to ensure that the self-resetting suspended magnetic generator 100 can generate a voltage greater than 10 V each time it is operated to meet the needs of driving the corresponding load, the movement speed of the return part 12 is preferably set to be greater than 0.1 m/s.

It is worth mentioning that the abutting part 121 of the return part 12 is arranged opposite to the bottom end surface 3121 of the driving tube 312, so there is a large acting area between them, which can generate a strong magnetic interaction. The magnetic attraction in the second magnetic gap 305 is greater than that in the first magnetic gap 302. Therefore, even if the width of the second magnetic gap 305 exceeds 2 mm, the return part 12 can be automatically adsorbed to the driving tube 312 when the driving force of the driving part 11 is removed.

In particular, the top cover 31 includes the driving tube 312, and the driving tube 312 constitutes a third magnetic wall 3103 of the top cover 31. The third magnetic wall 3103 extends downward from the inner side of the first magnetic wall 3101 and is perpendicular to the first magnetic wall 3101. Corresponding to the cross-sectional structure of the self-resetting suspended magnetic generator 100 in Figures 8A and 8B, the third magnetic wall 3103, the first magnetic wall 3101, the second magnetic wall 3102, the side magnetic wall 3202, and the bottom magnetic wall 3201 form two mirror-image C-like enclosed shapes that are symmetric left and right in the self-resetting suspended magnetic generator 100. The gap between the first magnetic wall 3101 and the bottom magnetic wall 3201 is small, and the gap width is only the sum of the thickness of the return part 12, the second magnetic gap 305, and the first magnetic gap 302. Preferably, the minimum gap between the first magnetic wall 3101 and the bottom magnetic wall 3201 is set to be no more than 5 mm, so that a high magnetic induction intensity can be maintained. Further, by comprehensively designing various parameters, the self-resetting suspended magnetic generator 100 has high power generation efficiency and a good driving feel while having a small volume. Preferably, the second magnetic gap 305 is set to be greater than or equal to 0.4 mm, and the first magnetic gap 302 is set to be greater than 0.1 mm.

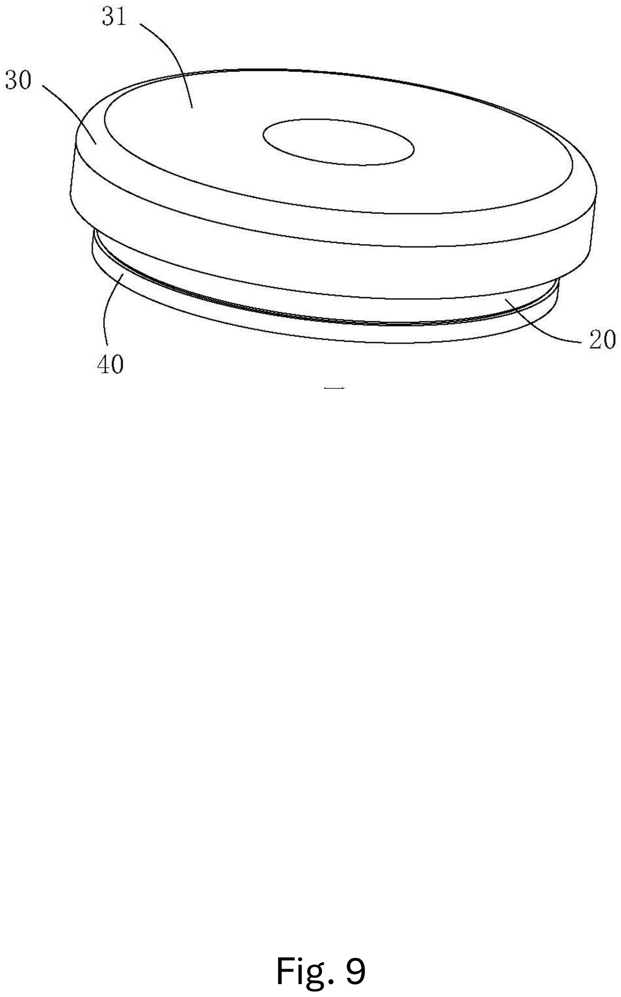

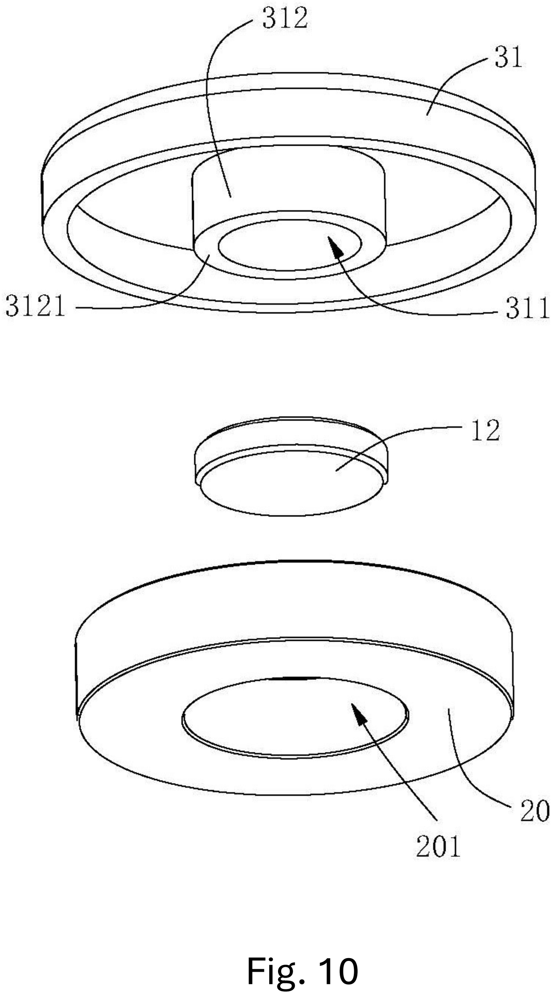

Further, in some embodiments of the present invention, the bottom cover 32 and the coil bracket 40 of the housing 30 may not be provided. Specifically, referring to Figures 9 to 11B in the drawings of the specification of the present invention, a self-resetting suspended magnetic generator 100 according to another embodiment of the present invention is illustrated. Compared with the self-resetting suspended magnetic generator 100 according to the preferred embodiment of the present invention, the self-resetting suspended magnetic generator 100 according to this other embodiment of the present invention has a simpler structure. The self-resetting suspended magnetic generator 100 includes the upper cover 31, the hollow coil 20, the driving part 11, and the return part 12. The upper cover 31, the hollow coil 20, the driving part 11, and the return part 12 are concentrically and axially stacked. The upper cover 31 includes the driving hole 311 and the driving tube 312. The driving tube 312 and the upper cover 31 can be manufactured separately and then assembled, or integrally formed, and the present invention does not limit this.

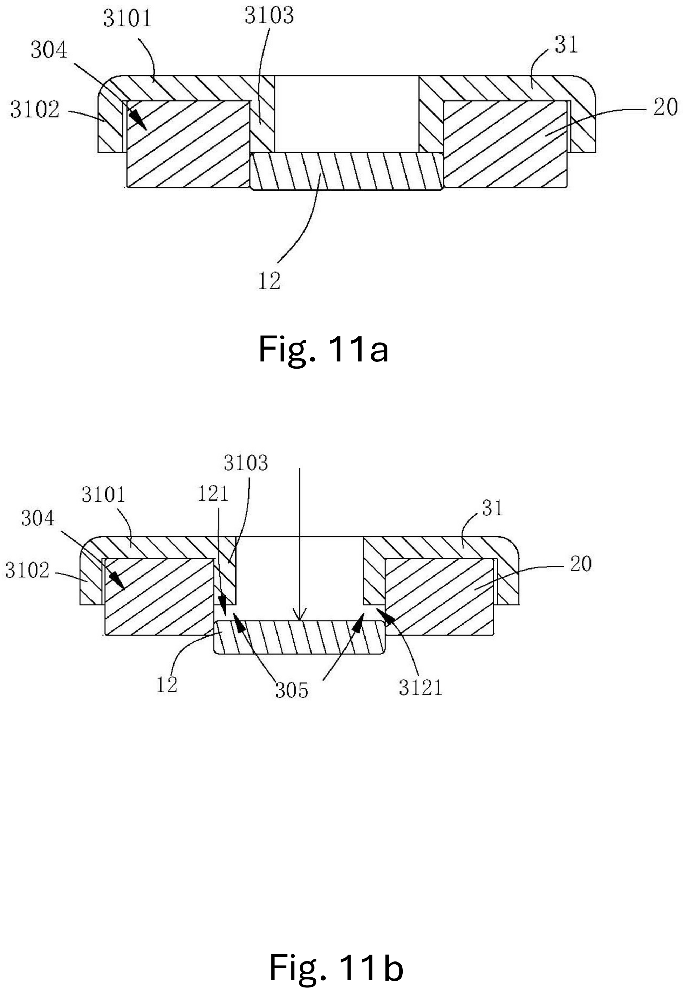

In particular, the driving tube 312 constitutes the third magnetic wall 3103 of the top cover 31 in the top cover 31. Corresponding to the cross-sectional structure of the self-resetting suspended magnetic generator 100 in Figures 11A and 11B, the third magnetic wall 3103, the first magnetic wall 3101, and the second magnetic wall 3102 form two mirror-image inverted C-like enclosed shapes that are symmetric left and right in the self-resetting suspended magnetic generator 100, so as to exactly accommodate the hollow coil 20. The second magnetic wall 3102 can not only diffuse the magnetic field to the outside of the hollow coil 20 but also play a role in protecting the hollow coil 20.

It is worth mentioning that in the initial state, this embodiment can provide a strong static N-S penetrating magnetic field for the hollow coil 20, instead of only providing a single-pole magnetic field of N-pole or S-pole; that is, in the initial state, the N-pole and S-pole of the return part 12 simultaneously provide a penetrating strong magnetic field for the hollow coil 20 through the housing 30, so as to increase the power generation efficiency and reduce the magnetic resistance; as shown in Figures 7, 8A, and 8B, in the static state, the magnetized surface (magnet N-pole) of the return part 12 abuts against the driving tube 312, and the N-pole magnetic induction lines of the return part 12 are conducted to the S-pole of the return part 12 through the third magnetic wall 3103 formed by the driving tube 312, then through the first magnetic wall 3101, the second magnetic wall 3102, the side magnetic wall 3202, and the bottom magnetic wall 3201, forming a closed magnetic conduction. In this way, the static magnetic field obtained by the hollow coil 20 in the initial state is very strong; although there is the first magnetic gap 302 in this closed magnetic conduction loop, the first magnetic gap 302 is relatively narrow, so the magnetic resistance effect is small. Therefore, the entire closed magnetic conduction loop still has a very strong initial magnetic field, forming a saturated magnetic field.

As shown in Figure 8B, when the driving part 11 drives the return part 12 to separate from the driving tube 312 instantaneously, the strength of the saturated magnetic field decreases rapidly. As the return part 12 moves further away from the driving tube 312, when the abutting part 121 of the return part 12 is roughly flush with the bottom magnetic wall 3201, the bottom magnetic wall 3201 changes from being close to the S-pole of the return part 12 to being close to the N-pole. Therefore, the magnetic field strength in the hollow coil 20 changes drastically, so that this embodiment can efficiently generate an induced pulse output. It can be understood that when this embodiment is reset automatically, an electrical pulse will be output again.

In particular, in this embodiment, compared with the single-pole magnetic field using only the N-pole or S-pole, the N-S penetrating magnetic field has lower magnetic resistance, and the energy generated by the power generation device is increased several times, which better reflects the invention purpose of the present invention of high efficiency and small volume.

It is worth mentioning that in this other embodiment of the present invention, the hollow coil 20 is sleeved on the outer periphery of the driving tube 312, so the driving tube 312 fixes and limits the hollow coil 20. In some embodiments, the hollow coil 20 is allowed to be designed to be thin so that the thickness of the hollow coil 20 is equal to the length of the driving tube 312, so that the hollow coil 20 is only sleeved on the outer periphery of the driving tube 312. A gap is provided between the inner side of the hollow coil 12 and the outer side of the return part 12, so that the return part 12 moves in the hollow channel 201 when driven by the driving part 11.

Initially, the return part 12 is magnetically adsorbed to the bottom end surface 3121 of the driving tube 312, and the bottom end surface 3121 of the driving tube 312 and the abutting part 121 of the return part 12 are tightly adsorbed together under the action of magnetic force. At this time, the hollow coil 20 is in a static saturated magnetic field; when the driving part 11 drives the return part 12, the return part 12 moves away from the driving tube 312. At this time, the hollow coil 20 is converted from a static saturated magnetic field environment to a disturbed magnetic field environment, that is, the hollow coil 20 is disturbed by the dynamically changing magnetic field, so the hollow coil 20 generates an induced electromotive force. Since the magnetic surface of the return part 12 (the abutting part 121) is arranged opposite to the bottom end surface 3121 of the driving tube 312, the magnetic force of the return part 12 on the side where the abutting part 121 is located is always greater than the magnetic force on the peripheral side of the return part 12. Therefore, there is a large area between the return part 12 and the driving tube 20, resulting in a strong magnetic interaction. Even if the distance between the return part 12 and the driving tube 20 exceeds 2 mm, they can be automatically magnetically adsorbed together again when the external force is removed. Corresponding to the state where the driving tube 312 in the second embodiment of the present invention is arranged in a ring shape, the bottom end surface 3121 of the driving tube 312 is annularly adsorbed to the abutting part 121 of the return part 12. The middle part of the driving tube 312 is hollow to accommodate the driving part 11, which improves the power generation efficiency of the self-resetting suspended magnetic generator 100 and makes the pressing feel soft. Optionally, in some embodiments, the bottom end surface 3121 of the driving tube 312 may also be adsorbed to the abutting part 121 of the return part 12 in a C-shape or U-shape.

It is worth mentioning that in the present invention, the center of the return part 12 is opposite to the center of the driving hole 311, that is, the center position of the return part 12 and the center position of the driving hole 311 are arranged concentrically. The center of the driving part 11 is also opposite to the center of the return part 12. The driving part 11 extends into the driving tube 312 from the top end of the driving tube 312, and drives the return part 12 located at the bottom end of the driving tube 312 when being forced to drive, so as to drive the return part 12 to move away from the top cover 31. When the driving force of the driving part 11 is removed, the return part 12 is attracted to the top cover 31 under the magnetic attraction effect and moves back towards the top cover 31, thereby being abutted against the bottom end of the driving tube 312 again and returning to the initial position. The bottom end surface 3121 of the driving tube 312 and the abutting part 121 of the return part 12 are adsorbed together again under the action of magnetic force.

Preferably, the movement stroke of the return part 12 in the suspended magnetic channel is greater than or equal to 0.5 mm and less than or equal to 6 mm. That is, in the state where the return part 12 is driven, the distance between the return part 12 and the bottom end surface 3121 of the driving tube 312 is in the range of 0.5 mm to 6 mm, so as to ensure both the power generation capacity of the self-resetting suspended magnetic generator 100 and the miniaturized and thin design of the self-resetting suspended magnetic generator 100. Specifically, if the movement stroke of the return part 12 is less than 0.5 mm, the induced energy that can be generated by the self-resetting suspended magnetic generator 100 is relatively low; if the movement stroke of the return part 12 is too long, the thickness and volume of the self-resetting suspended magnetic generator 100 will be too large.

It is worth mentioning that preferably, when the return part 12 is driven, the side of the return part 12 away from the driving hole 311 protrudes from the side of the hollow coil 20 away from the driving hole 311, so as to ensure the power generation efficiency of the self-resetting suspended magnetic generator 100 based on a sufficient movement stroke.

Preferably, the magnet/magnetic conductive volume of the return part 12 is set to be greater than 32 cubic millimeters, so as to ensure that the self-resetting suspended magnetic generator 100 has a sufficient magnetic field density.

In particular, in the present invention, the size of the return part 12 is equal to the surface area of the bottom of the driving tube 312, so as to ensure the stability of the return part 12 during movement and reduce the possible shaking of the return part 12 when 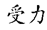 .

It is worth mentioning that in the present invention, the number of turns of the hollow coil 20 is set to be greater than 450 turns and less than 1100 turns, so as to balance the power generation output efficiency of the hollow coil 20 and the volume of the self-resetting suspended magnetic generator 100. Specifically, different from the coil winding method in the prior art, due to the superposed thickness of multiple components and the need to reserve the movement space of the return part 12, the longitudinal thickness of the hollow coil 20 in the present invention is limited. The only way to improve the output efficiency of the hollow coil 20 is to increase the number of turns in the diameter direction of the hollow coil 20. However, too many turns will increase the length of the wire in each layer of the coil, leading to an increase in resistance. Therefore, the number of turns of the hollow coil 20 is set to be greater than 450 turns and less than 1100 turns, which balances both the output efficiency and the miniaturized design.

In particular, when the self-resetting suspended magnetic generator 100 is mounted on the corresponding housing, a safety distance of at least 0.1 mm is maintained between the return part 12 and the corresponding housing, so as to ensure the safety of the return part 12 during movement and prevent it from breaking due to tens of thousands of movements.

It is worth mentioning that on the premise of ensuring that the power generation capacity of the self-resetting suspended magnetic generator 100 can meet the use needs of the corresponding load, the top cover 31 can also be partially cut off. For example, in some modified embodiments, the second magnetic wall 3102 of the top cover 31 may not be provided, and the present invention does not limit this. Similarly, on the premise of ensuring that the power generation capacity of the self-resetting suspended magnetic generator 100 can meet the use needs of the corresponding load, the driving tube 312 can also be partially cut off. For example, part of the side surface of the driving tube 312 is cut off, so that the longitudinal cross-section of the driving tube 312 changes from a complete closed figure to a figure with an opening.

In particular, at least one of the driving part 11 and the return part 12 of the suspended magnetic component 10 is a permanent magnet to meet the disturbance of the magnetic induction lines of the hollow coil 20 and realize the reset of the return part 12. For specific reference to Figures 12 to 14, the optional material setting modes of the suspended magnetic component 10 are respectively illustrated.

Corresponding to Figure 12, the driving part 11 is a permanent magnet, and the return part 12 is a magnetic conductive body to conduct the magnetism of the driving part 11 and ensure the magnetic attraction between the return part 12 and the top cover 31. With the driving part 11 as a permanent magnet, the movement of the driving part 11 in the suspended magnetic channel forms a change in magnetic flux, which is beneficial to improving the power generation efficiency of the self-resetting suspended magnetic generator 100 based on the relative movement of a large area.

Corresponding to Figure 13, preferably, the return part 12 is a permanent magnet, and the driving part 11 abuts against the return part 12 to drive the return part 12. The driving part 11 is a non-magnetic conductive body. For the purpose of reducing the friction between the driving part 11 and the housing 30, the driving part 11 is preferably made of self-lubricating nylon material, and the return part 12 is suspended in the suspended magnetic channel under the magnetic attraction effect with the top cover 31.

Corresponding to Figure 14, both the return part 12 and the driving part 11 are permanent magnets. The movement of the suspended magnetic component 10 in the suspended magnetic channel forms a change in magnetic flux, which is beneficial to improving the power generation efficiency of the self-resetting suspended magnetic generator 100 based on the relative movement of a large area.

Optionally, in some embodiments, the driving part 11 and the return part 12 may also be integrally provided to improve the modular integrity of the components of the self-resetting suspended magnetic generator 100.

Preferably, in the self-resetting suspended magnetic generator 100 disclosed in the present invention, the hollow coil 20 is arranged in a ring shape. Referring to Figure 15, the magnetic induction lines in all directions of the annular hollow coil 20 are uniform. Therefore, when the suspended magnetic component 10 moves relative to the hollow coil 20, the disturbance to the magnetic induction lines in all directions is more uniform, and the uniformity of the electric quantity generated during the power generation process of the self-resetting suspended magnetic generator 100 is improved. That is, the electric quantity generated by the same displacement in the same time period tends to be consistent, ensuring the power generation stability of the self-resetting suspended magnetic generator 100. In particular, corresponding to the preferred annular design of the hollow coil 20, the corresponding driving part 11 is also preferably arranged as a cylinder or a cylinder-like shape, and the return part 12 is arranged as a circular sheet or a cylinder-like shape. Thus, when the suspended magnetic component 10 moves relative to the hollow coil 20, the disturbance to the magnetic induction lines in all directions is uniform, the formed change in magnetic flux is more uniform, and the uniformity of the electric quantity generated during the power generation process of the self-resetting suspended magnetic generator 100 is ensured.

It is worth mentioning that specifically in these embodiments of the present invention, the driving part 11 is designed in a cylindrical shape and has a cone shape at one end away from the return part 12 to form a cylinder-like shape. The pressing strength of the driving part 11 is improved based on the conical design of the driving part 11. When an external force is applied to press the conical driving part 11, the driving force is relatively centered, thereby preventing the driving part 11 from shaking due to uneven force during movement, further ensuring the stability of the return part 12 during movement, preventing the return part 12 from rolling over, or preventing the abutting part 121 of the return part 12 from being unable to be separated from the driving tube 312 synchronously as a whole.

One end of the driving part 11 close to the return part 12 has a driving groove recessed towards the other end of the driving part 11. The direct contact area between the driving part 11 and the return part 12 is reduced based on the recessed design of the driving part 11, which is beneficial to reducing the direct impact area between the driving part 11 and the return part 12, extending the service life of the self-resetting suspended magnetic generator 100, and at the same time, beneficial to reducing the noise of the self-resetting suspended magnetic generator 100.

In particular, in this embodiment, the diameter of the return part 12 arranged in a circular sheet shape is larger than the aperture of the driving hole 311, so as to ensure that the return part 12 is magnetically adsorbed to the top cover 31 when the return part 12 is arranged in the suspended magnetic channel and at least one of the driving part 11 and the return part 12 is a permanent magnet.

It is worth mentioning that in some embodiments, the top end of the driving part 11 can also be set to a flat top shape or a dome shape to facilitate direct pressing and driving by hand. The return part 12 is set to perform piston-like movement along the hollow channel 201 of the hollow coil 20. When the return part 12 is pushed by the driving part 11, if the pushing force is large enough to overcome the magnetic attraction force of the return part 12 to the driving tube 312, the return part 12 and the driving tube 312 are quickly separated instantaneously, but they still maintain mutual attraction force and have magnetic force for automatic reset. The return part 12 flies towards the bottom cover 32 at a set speed in the hollow channel 201 of the hollow coil 20 at high speed, and a first induced electromotive force is generated in the hollow coil 20; when the force pushing the driving part 11 is removed, the return part 12 rebounds under the action of magnetic attraction, the return part 12 is re-adsorbed to the driving tube 312, and a second induced electromotive force is generated in the hollow coil 20.

It is worth mentioning that in some embodiments, in order to further reduce the cost and simplify the structure, the driving part 11 can be arranged on the inner side of the button of the corresponding housing, that is, the driving part 11 and the button of the corresponding housing are integrally formed. When the button of the housing is pressed, the driving part 11 located on the housing extends into the driving tube 312 to drive the return part 12. In addition, the driving part 11 can also be set as a rubber part, which not only has elasticity to improve the pressing feel but also can be integrally formed with a waterproof film to cover the present invention, playing the dual beneficial roles of waterproofing and reducing noise. The waterproof film can wrap the self-resetting suspended magnetic generator 100.

In particular, when the driving part 11 is set as a rubber part, the cross-section of the side of the driving part 11 abutting against the return part 12 is a flat surface or a hollow cylindrical annular structure.

In particular, in some embodiments, when the return part 12 is driven, the abutting part 121 of the return part 12 is roughly flush with the inner side edge of the bottom opening 321 of the lower cover 32; optionally, in some embodiments, when the return part 12 is driven, the other side opposite to the abutting part 121 of the return part 12 protrudes from the bottom opening 321 of the bottom cover 32; optionally, in some embodiments, in the initial state, the other side of the abutting part 121 of the return part 12 protrudes from the bottom opening 321 of the bottom cover 32, and the present invention does not limit this.

It is worth mentioning that the centralized arrangement and centralized driving mode of the driving part 11 disclosed in the present invention greatly simplifies the complexity of the housing design. It is only necessary to arrange a vertical button above the driving part 11 for commercialization; compared with the side driving mode in the prior art, the centralized arrangement and centralized driving mode of the driving part 11 in the present invention can significantly reduce the volume of the product and the stability during operation, so that the energy generated each time tends to be consistent, and the mechanical noise is significantly lower than that in the prior art.

In particular, compared with the manual pressing generator in the prior art, the present invention can set the output electric power according to needs. The micro manual pressing generator in the prior art has upper and lower magnetic conductive plates for limiting and needs to be fixed together with the magnet. Therefore, if it is desired to improve the output power of the generator, the volume of the magnet must be increased. However, limited by the upper and lower magnetic conductive plates and fixed parts, the volume of the magnet is difficult to change, so it is inconvenient to adjust the output power of the generator; while according to the needs of the present invention, the power generation power can be adjusted by appropriately increasing or decreasing the thickness of the return part 12. Since no component is fixedly connected to the return part 12, the volume change of the return part 12 does not affect other components, and it is relatively easy to increase or decrease the thickness of the return part 12. For example, driving an FSK standard communication circuit requires about 200 uJ of energy, while driving an ASK standard communication circuit requires about 300 uJ of energy. At this time, the power generation power can be adjusted by replacing the return part 12 with a corresponding thickness without re-adjusting the structure of the generator or re-opening the mold, which has good economic benefits.

In particular, for the purpose of improving the operation feel of the self-resetting suspended magnetic generator 100, the present invention also provides a spring in the self-resetting suspended magnetic generator 100 to improve the pressing feel of the self-resetting suspended magnetic generator 100. For specific reference to Figure 16, the suspended magnetic component 10 further includes an energy storage part 13. Before the driving part 11 is forced to drive the return part 12 and overcome the magnetic attraction between the return part 12 and the top cover 31, the energy storage part 13 is driven by the driving part 11 to store potential energy and generate deformation to form a forced displacement of the driving part 11, thereby avoiding the sudden displacement of the driving part 11 at the moment when the magnetic attraction between the return part 12 and the top cover 31 is overcome, improving the pressing feel of the self-resetting suspended magnetic generator 100, and realizing the acceleration of the movement of the return part 12 through the instantaneous release of the potential energy of the energy storage part 13, further improving the power generation efficiency of the self-resetting suspended magnetic generator 100. Specifically, in this embodiment, the energy storage part 13 is arranged between the driving part 11 and the return part 12. When the driving part 11 is stressed, the driving force of the driving part 11 first acts on the energy storage part 13. The energy storage part 13 is deformed under the driving of the driving part 11 to store the driving force of the driving part 11. The driving part 11 continues to apply the driving force, and the energy storage part 13 transmits the driving force of the driving part 11 to the return part 12 until the magnetic attraction between the return part 12 and the top cover 31 is overcome, so that the return part 12 moves along the suspended magnetic channel, thereby forming a change in magnetic flux to generate electrical energy. In this way, the sudden displacement of the driving part 11 at the moment when the magnetic attraction between the return part 12 and the top cover 31 is overcome is avoided, and the pressing feel of the self-resetting suspended magnetic generator 100 is improved. In the state where the driving force of the driving part 11 is removed, the return part 12 is reset under the magnetic attraction effect of the top cover 31, and the energy storage part 13 forms a reset buffer for the return part 12, preventing the return part 12 from directly impacting the driving part 11, which is beneficial to extending the service life of the self-resetting suspended magnetic generator 100. At the same time, based on the buffer of the reset force of the return part 12 by the energy storage part 13, the sudden upward ejection impact of the driving part 11 can be avoided, ensuring the stability of the corresponding button and the use safety of the self-resetting suspended magnetic generator 100.

In particular, the energy storage part 13 arranged between the driving part 11 and the return part 12 can be installed by means of the space objectively existing in the driving part 11 to ensure the miniaturization of the self-resetting suspended magnetic generator 100. Specifically, the energy storage part 13 is accommodated in the driving groove of the driving part 11 and presses against the return part 12, so as to be arranged by means of the recessed driving groove of the driving part 11, making the structure of the self-resetting suspended magnetic generator 100 more compact.

It is worth mentioning that in some embodiments of the present invention, the driving part 11 can be designed in two sections, that is, the driving part 11 can be composed of two sections stacked together, and the energy storage part 13 is arranged between the two sections of the driving part 11. In this way, the situation that the driving part 11 tilts when driving the return part 12 due to the uneven end surface of the energy storage part 13 or the unbalanced shaking movement of the elastic element can be avoided, thereby ensuring the working stability of the self-resetting suspended magnetic generator 100.

For specific reference to Figure 17 in the drawings of the specification of the present invention, the driving part 11 is composed of two sections combined, so that the energy storage part 13 can be hidden inside the driving part 11, which not only reduces the additional space required by the energy storage part 13 but also makes the overall structure of the self-resetting suspended magnetic generator 100 more compact. The driving part 11 includes a first driving part 111 and a second driving part 112. The energy storage part 13 is arranged between the first driving part 111 and the second driving part 112 of the driving part 11. Preferably, the first driving part 1101 and the second driving part 1102 wrap the energy storage part 13, so that the driving part 11 has elasticity when being pressed and driven.

Optionally, in some embodiments, the second driving part 112 is arranged below the energy storage part 13 to prevent the energy storage part 13 from tilting during the compression and energy storage process, which will cause the periphery of the return part 12 to be unable to be separated from the driving tube 312 in a balanced and simultaneous manner. This unbalanced separation will lead to a significant reduction in power generation power. The second driving part 1102 has the function of keeping the energy storage part 13 moving in a balanced axial direction. The second driving part 112 can be set in a flat-bottomed barrel shape. The barrel-shaped side of the second driving part 112 designed in a flat-bottomed barrel shape will not shake left and right under the limiting effect of the driving hole 311, so that the piston-like movement of the driving part 11 is more stable.

It is worth mentioning that in this modified embodiment, the self-resetting suspended magnetic generator 100 further includes an upper cover 51 and a lower cover 52. The upper cover 51 and the lower cover 52 are closed up and down to wrap the self-resetting suspended magnetic generator 100 as a whole. The middle part of the upper cover 51 has an opening concentric with the top cover 31, so that the top end of the driving part 11 can be exposed. The upper cover 51 can movably limit the driving part 11 to ensure that the driving part 11 will not fall off from the self-resetting suspended magnetic generator 100. The center position of the bottom of the lower cover 52 has a through hole with a thickness of less than 6 mm to ensure the movement stroke of the return part 12 and prevent the return part 12 from colliding with other objects to generate strong noise during movement.

In particular, in some embodiments, for the purpose of preventing the return part 12 from colliding with other objects to generate strong noise during movement, a buffer part is further arranged on the side of the return part 12 opposite to the driving tube 312. When the return part 12 collides with the buffer part, the noise generated by the collision of the return part 12 with other components during the piston-like movement can be reduced. The buffer part is made of shock-absorbing materials such as rubber, sponge, and shock-absorbing shrapnel.

Optionally, in some embodiments, the energy storage part 13 is arranged at one end of the driving part 11 away from the return part 12, that is, the energy storage part 13 is arranged on the driving part 11. When the self-resetting suspended magnetic generator 100 is operated, the corresponding pressing force first acts on the energy storage part 13, and the energy storage part 13 is deformed under force to improve the pressing feel until the magnetic attraction between the return part 12 and the top cover 31 is overcome, so that the return part 12 moves along the suspended magnetic channel. In the state where the driving force of the driving part 11 is removed, the return part 12 is reset under the magnetic attraction effect of the top cover 31, and the energy storage part 13 forms a reset buffer for the return part 12, which can avoid the sudden upward ejection impact of the driving part 11, ensuring the stability of the corresponding button and the use safety of the self-resetting suspended magnetic generator 100.

That is, the energy storage part 13 can also be arranged on the top of the driving part 11. In other words, as long as the basic concept of the present invention is met, the specific installation form of the energy storage part 13 is not limited, and the energy storage part 13 can also be implemented as a shrapnel, elastic rubber, magnetic elastic element, or other components with elasticity, and the present invention does not limit this.

Further, for the purpose of improving the power generation efficiency of the self-resetting suspended magnetic generator 100, referring to Figure 18 in the drawings of the specification of the present invention, the modified implementation schemes of the self-resetting suspended magnetic generator 100 based on the above purpose are respectively illustrated. Specifically, in these modified embodiments, the suspended magnetic component 10 further includes an auxiliary disturbance part 50. In this modified embodiment, the driving part 11 and the return part 12 are designed integrally, and the auxiliary disturbance part 50 is installed on the driving part 11 and located in the suspended magnetic channel. In the state where the driving part 11 is forced to drive the return part 12, the auxiliary disturbance part 50 moves along with the driving part 11 to form a change in magnetic flux. In the state where the force applied to the driving part 11 is removed, the auxiliary disturbance part 50 is driven by the reset of the return part 12 to form a change in magnetic flux, thereby improving the power generation efficiency of the self-resetting suspended magnetic generator 100 based on increasing the area of relative movement.

Further, the annular design of the hollow coil 20 can make the electric quantity generated during the power generation process of the self-resetting suspended magnetic generator 100 more uniform. However, it can be understood that different from the generators in the prior art whose shapes cannot be adjusted arbitrarily, the self-resetting suspended magnetic generator 100 of the present invention can also adopt other shape designs. For example, the self-resetting suspended magnetic generator 100 can be made into a flat circular shape or a long cylindrical shape according to the application, so as to adapt to different application scenarios. For example, in the use scenario of some cabinet doors, since the thickness of the cabinet door panel is relatively thin, the self-resetting suspended magnetic generator 100 can be set into a cylindrical structure with a diameter of 10 mm for embedded installation to meet the corresponding installation and use needs. That is, the self-resetting suspended magnetic generator 100 has various optional design modes and flexible characteristics of being able to be round or flat, so that its shape can be changed, and thus it can meet various application scenarios.

For detailed reference to Figure 19 in the drawings of the specification, a self-resetting suspended magnetic generator 100A according to a second embodiment of the present invention is illustrated. The specific component configuration of the self-resetting suspended magnetic generator 100A is the same as that of the self-resetting suspended magnetic generator 100, except that the shape of the self-resetting suspended magnetic generator 100A is different. Specifically, in the second embodiment, the hollow coil of the self-resetting suspended magnetic generator 100A is arranged in a rectangular shape, the corresponding driving part of the suspended magnetic component is a square column, and the return part is a rectangular sheet. The size of the self-resetting suspended magnetic generator 100A is close to the size of the hollow coil, so the self-resetting suspended magnetic generator 100A is also rectangular as a whole.

For detailed reference to Figure 20 in the drawings of the specification, a self-resetting suspended magnetic generator 100B according to a third embodiment of the present invention is illustrated. The specific component configuration of the self-resetting suspended magnetic generator 100B is the same as that of the self-resetting suspended magnetic generator 100, except that the shape of the self-resetting suspended magnetic generator 100B is different. Specifically, in the third embodiment, the hollow coil of the self-resetting suspended magnetic generator 100B is arranged in a star shape, the corresponding driving part of the suspended magnetic component can also be set as a star column, and the return part can also be set as a star sheet. The size of the self-resetting suspended magnetic generator 100B is close to the size of the hollow coil, so the self-resetting suspended magnetic generator 100B can also be star-shaped as a whole to meet the aesthetic requirements.

That is, the overall size of the self-resetting suspended magnetic generator is close to the size of the hollow coil, so the self-resetting suspended magnetic generator has a higher flexibility in structural design, can flexibly meet different application requirements of the self-resetting suspended magnetic generator, and meets the current personalized configuration requirements. In addition, the self-resetting suspended magnetic generator can also be flexibly designed into various shapes, and the shape of the self-resetting suspended magnetic generator can be adjusted or changed according to actual needs to meet the current personalized configuration requirements.

To further understand the present invention, the present invention also provides a power generation method of the self-resetting suspended magnetic generator 100, which includes the steps of:
A. Initially, the return part 12 is adsorbed and maintained at an initial position under the magnetic attraction effect with the top cover 31;
B. Applying a force to the driving part 11 to drive the return part 12 to move along the suspended magnetic channel, so as to disturb the magnetic induction lines of the hollow coil 20 to generate electrical energy for the first time, and the return part 12 is suspended in the suspended magnetic channel under the magnetic attraction effect with the top cover 31;
C. Removing the force applied to the driving part 11, and the return part 12 is reset under the magnetic attraction effect with the top cover 31 to disturb the magnetic induction lines of the hollow coil 20 again to generate electrical energy for the second time.

Further, the overall size of the self-resetting suspended magnetic generator 100 is close to the size of the hollow coil 20. Intuitively, the size of the self-resetting suspended magnetic generator 100 is less than that of a one-yuan coin, so that the self-resetting suspended magnetic generator 100 can be applied to many micro-devices, and the application scenarios of the self-resetting suspended magnetic generator 100 are more abundant and flexible.

Further, the present invention can also provide a self-powered selfie stick to solve the technical defect that the existing selfie sticks need battery power supply. Specifically, the self-resetting suspended magnetic generator 100 has high power generation efficiency while being miniaturized, so it is suitable for various micro-application scenarios. For example, it can be embedded in a selfie stick to form a self-powered selfie stick device. When a user presses the photo-taking button of the self-powered selfie stick device, the self-resetting suspended magnetic generator 100 is driven to generate electricity to supply power for sending the corresponding photo-taking command, avoiding the environmental problems caused by battery power supply and the inconvenience of frequent replacement or charging. At the same time, the requirements for the use environment are significantly reduced, ensuring the safety of the selfie stick in most outdoor application scenarios. Moreover, due to the maintenance-free feature of the self-powered selfie stick device, the embarrassing situation of running out of power during outdoor use is avoided.

Only when the corresponding self-resetting generator is miniaturized can it be embedded in the selfie stick, solving the technical defect that the existing selfie sticks cannot be installed with a generator. In particular, it is a technical innovation of the present invention to miniaturize the volume of the micro-generator and then embed it in the selfie stick to form a self-powered selfie stick product, and the structure of the generator is not limited to the generator structure disclosed in the present invention; the overall technical concept of forming a self-powered selfie stick after miniaturizing other power generation structures also belongs to the technical scope disclosed in the present invention.

Specifically, referring to Figure 21 in the drawings of the specification of the present invention, a self-powered selfie stick 300 including the self-resetting suspended magnetic generator 100 is illustrated. The self-powered selfie stick 300 further includes a clamping part 320 and a handle part 310. The clamping part 320 is mounted on the handle part 310. The self-resetting suspended magnetic generator 100 is arranged on the handle part 310. The driving part 11 is linked to the corresponding control key 330 on the handle part 310, and drives the return part 12 to move along the suspended magnetic channel when the control key 330 is pressed. The return part 12 is attracted to the top cover 31 under the magnetic attraction effect and is reset when the force applied to the driving part 11 is removed, so that the suspended magnetic component 10 moves in a suspended manner along the suspended magnetic channel to form a change in magnetic flux. The self-resetting suspended magnetic generator 100 is electrically connected to a communication circuit, and the communication circuit can be arranged inside the self-resetting suspended magnetic generator 100 or inside the handle part 310. The communication circuit can transmit wireless signals to control corresponding electronic devices such as mobile phones and tablet computers to take photos. When the control key 330 of the self-powered selfie stick 300 is pressed, the self-resetting suspended magnetic generator 100 generates electrical energy to supply power to the communication circuit, and the communication circuit sends a photo-taking command to the electronic device. When the control key 330 is released, the self-resetting suspended magnetic generator 100 automatically returns to the initial state for the next photo-taking operation. The electronic device clamped by the clamping part 320 is preferably a wireless terminal device, such as a mobile phone, a camera, etc.

It is also worth mentioning that the self-resetting suspended magnetic generator 100 has high power generation efficiency while being miniaturized, so it is suitable for various micro-application scenarios. For example, it can be applied to a wireless keyboard to form a self-powered wireless keyboard. Since the self-resetting suspended magnetic generator 100 has a compact structure and its overall size is set to be close to the size of the hollow coil, each self-resetting suspended magnetic generator 100 can serve as a button on the self-powered wireless keyboard. When a user presses a button, the self-resetting suspended magnetic generator 100 is driven to generate electricity and supply power to send the corresponding button command, avoiding the environmental problems caused by battery power supply and the inconvenience of frequent replacement or charging.

For further reference to Figures 22 and 23 in the drawings of the specification of the present invention, a non-blind area pressing driving device 400 including the self-resetting suspended magnetic generator 100 is illustrated. The design of the non-blind area pressing driving device 400 is beneficial for the operator to perform pressing operation without blind area only by tactile touch on the non-blind area pressing driving device 400 without visual identification. No matter which position of the non-blind area pressing driving device 400 is pressed, the operation can be performed normally, without the need to visually see the direction and specific button position clearly as in the existing products before operation. The operation is more convenient and fast, and it is beneficial for people with physical disabilities to operate. In addition, due to this special advantage, some animals can also operate and use it after simple training.

Specifically, the non-blind area pressing driving device 400 includes the self-resetting suspended magnetic generator 100, a movable shell 60, and a fixed shell 65. The self-resetting suspended magnetic generator 100 is accommodated between the movable shell 60 and the fixed shell 65 and located at the center of the cavity formed by the movable shell 60 and the fixed shell 65, so that when the movable shell 60 is pressed without blind area, the self-resetting suspended magnetic generator 100 can be driven to generate electricity. The movable shell 60 is movably arranged above the fixed shell 65 in a non-blind area pressing manner. Specifically, the movable shell 60 includes a panel 61, a first side edge 62, a second side edge 63, and a central axis 66. The first side edge 62 extends downward from the edge of the panel 61, the second side edge 63 extends downward from the panel 61, and an accommodating space 601 is formed between the second side edge 63 and the first side edge 62. The first side edge 62 is arranged around the panel 61, and the second side edge 63 is implemented as a movable fixed arm, which can be movably connected to the fixed shell 65.

Further, the number of the second side edges 63 is multiple, and the multiple second side edges 63 are arranged at intervals. Specifically, in this embodiment, at least 3 second side edges 63 are arranged on the inner side of the panel 61 at intervals greater than 10 mm. Preferably, in this embodiment, the number of the second side edges 63 is set to 4 to form 4 fixed arms, which are divided into two groups and arranged opposite to each other. Each group is arranged perpendicular to each other, that is, one second side edge 63 is arranged in each of the left and right directions, and one second side edge 63 is arranged in each of the up and down directions, so as to form a layout with one second side edge 63 in each of the up, down, left, and right directions. That is, the second side edge 63 does not need to be an annular structure around the movable cover 60.

Further, the second side edge 63 is provided with at least one hook 631. Preferably, the second side edge 63 is provided with 4 hooks 631, and the fixed shell 65 is provided with the same number of fixed buckles 64 corresponding to the hooks 631 to cooperate with the hooks 631 to complete the pivotal action and lock the movable shell 60 to prevent it from falling off during movement. The specific position and specific form of the fixed buckles 64 are not limited, as long as they can cooperate with the hooks 631 to complete the pivotal action and lock the movable shell 60 to prevent it from falling off during movement, and the present invention does not limit this.

Preferably, in this embodiment of the present invention, for the purpose of facilitating assembly and maintaining the flatness of the side edge of the accommodating space 601, the hook 631 is arranged toward the self-resetting suspended magnetic generator 100.

Further, the central axis 66 is located at the center of the panel 61, and the central axis 66 abuts against the driving part 11 of the self-resetting suspended magnetic generator 100, which not only plays a role of central balance support but also can link the central axis 66 to drive the self-resetting suspended magnetic generator 100 to generate electricity when the panel 61 moves.

It is worth mentioning that the fixed shell 65 includes a side edge 651 and a plurality of fixed buckles 64. The fixed buckles 64 are further provided with a guiding inclined surface 641, and the upper part of the side edge 651 is further provided with a cone part 6511, which is beneficial to easily and accurately align the assembly position when the movable shell 60 is installed, and the cone part 6511 avoids the movement space of the movable shell 60, which is beneficial to reducing the thickness of the device and has market competitiveness.

In particular, the guiding inclined surface 641 can guide the hook 631 to be installed more easily and accurately when the movable shell 60 is assembled. Preferably, in this embodiment of the present invention, the guiding inclined surface 641 is arranged on the side away from the fixed shell 65.

It is worth mentioning that the side edge 651 of the fixed shell 65 extends into the accommodating space 601. The accommodating space 601 refers to the empty area between the first side edge 62 and the second side edge 63. When the movable shell is pressed and moves, the accommodating space 601 can avoid the side edge 651. This design allows the second side edge 63 to act as a movable fulcrum for pivoting, while the first side edge 62 shields the internal parts and the slots on the side of the device, as well as the joint gap between the movable shell 60 and the fixed shell 65. Compared with the prior art, this design is more conducive to assembly, reduces the thickness of the device, and has a more attractive appearance, resulting in significant market economic benefits.

In particular, a ring groove 652 is further arranged in the middle of the fixed shell 65 for stably accommodating the self-resetting suspended magnetic generator 100.

It is worth mentioning that the top of the side edge 651 of the fixed shell 65 has an upper end surface 6512; the end of the first side edge 62 of the movable shell 60 is provided with a lower end surface 621, and the upper end surface 6512 and the lower end surface 621 are arranged in a staggered manner, so that the first side edge 62 can completely shield the internal parts, play a role in preventing foreign objects from entering, and also improve the aesthetic appearance of the product.

It is worth mentioning that for the purpose of facilitating assembly, the second side edge 63 is arranged on the inner side of the side edge 651 of the fixed shell 65.

To further elaborate, any position on the upper surface of the movable shell 60 of the non-blind area pressing driving device 400 can be pressed without blind area. Both the middle position and the edge position can be pressed to trigger the self-resetting suspended magnetic generator 100 to generate electrical energy. This is particularly important when applied to wireless emergency call button products. The self-resetting suspended magnetic generator 100 located in the middle position provides static supporting force for the non-blind area pressing driving device 100, i.e., in the static state, the suspended magnetic generator 100 provides supporting force for the movable shell 60, while multiple groups of hooks 631 on the second side edge 63 of the movable shell 60 are arranged opposite to each other, and the hooks 631 are movably hooked on the buckles 64 of the fixed shell 65 to form a pivotable state. When the left edge of the present invention is pressed, the pair of hooks 631 and buckles 64 on the right side start to pivot, achieving the beneficial effect of a rotating shaft; similarly, when the right edge of the non-blind area pressing driving device 400 is pressed, the pair of hooks 631 and buckles 64 on the left side start to pivot to form a rotating shaft; it can be seen that there is no fixed pivot shaft in the non-blind area pressing driving device 400. When one side is pressed, the pair of hooks 631 and buckles 64 on the opposite side form a pivotal relationship. This arrangement allows the middle position of the non-blind area pressing driving device 400 to also be pressed, thereby achieving the structural advantage of non-blind area pressing.

In particular, the driving position of the self-resetting suspended magnetic generator 100 is set as the center point of the non-blind area pressing driving device 400 to provide balanced supporting force for the movable shell 60. It is worth mentioning that, different from the spring support method in the prior art, the return part 12 of the self-resetting suspended magnetic generator 100 provides balanced supporting force for the movable shell 60 in the static state, which has a better pressing feel, can also reduce the space occupied by the spring, has lower cost, and the product can be made thinner.

It is worth mentioning that the energy storage part 13 can be arranged between the central axis 66 and the return part 12 to significantly improve the pressing comfort. Compared with the structure in the prior art where the button directly presses the magnetic group and then presses the spring, the operation comfort is significantly improved, and the sense of effort when pressing is also significantly reduced. The non-blind area pressing driving device 100 adopts a structure in which the central axis 66 of the movable shell 60 first presses the energy storage part 13, and then the energy storage part 13 drives the return part 12. This structure has two significant improvements compared with the prior art: first, the central axis 66 of the movable shell 60 first presses the energy storage part 13, avoiding the problem of stiff hand feeling when the central axis 66 directly presses the return part 12. If the central axis 66 directly presses the return part 12, when the driving force is greater than the magnetic attraction between the return part 12 and the driving tube 312, the two will be separated instantaneously, resulting in a sudden collapse and empty feeling of the pressing hand, with strong sense of frustration and large driving force during operation. However, if the pressing energy storage part 13 is arranged between the central axis 66 and the return part 12, the pressing hand feeling is significantly improved, so that there is a comfortable buffer stroke when the movable shell 60 is pressed, and the force increases slowly. When the final driving force is greater than the magnetic attraction between the return part 12 and the driving tube 312, the two are separated instantaneously, and the pressing force has a gradual process, which conforms to people's daily operation habits. Second, arranging the pressing energy storage part 13 between the central axis 66 and the return part 12 can also stabilize the electrical energy output by the self-resetting suspended magnetic generator 100, and the power generation power will not be affected by the speed of pressing. In this structure, no matter whether the user presses quickly or slowly, the self-resetting suspended magnetic generator 100 can output the set energy stably. It is worth mentioning that, based on the above disclosure of the present invention, the energy storage part 13 can also be arranged in the driving part 11 to achieve a more optimized stable buffering effect of the energy storage part 13. It can be understood that, according to the disclosure of the present invention, the connection mode between the central axis 66 and the energy storage part 13 is diverse, and the present invention does not limit this as long as non-blind area pressing can be realized and the beneficial effect of elastic and comfortable pressing hand feeling can be achieved.

It is worth mentioning that in some embodiments, the central axis 66 and the driving part 11 can be combined into the same component, but their functions remain unchanged.

In particular, when one side of the non-blind area pressing driving device 100 is pressed, the hooks 631 and buckles 64 on the opposite side form a pivot. Since the driving position is located in the middle of the movable shell 60, a labor-saving device is formed, which makes it easier to press the edge of the non-blind area pressing driving device 100, and is beneficial for pets to operate.

To further understand the present invention, the present invention also provides a non-blind area pressing power generation method, including the steps of:
A. In a static state, a generator 100 provides a balanced supporting force to the middle position of a movable shell 60;
B. Pressing the movable shell 60, so that a second side edge 63 at the edge of the movable shell 60 is pivotally connected to a buckle 64 of a fixed shell 65 below the movable shell 60, thereby forming a driving state of non-blind area pressing on the surface of the movable shell 60 to drive the generator 100 to generate electrical energy. In one embodiment, in step (A), an energy storage part 13 of the generator 100 supports a central axis 66 of the movable shell 60 to form a state where the movable shell 60 is balanced and supported by the generator 100.

In one embodiment, in step (A), a return part 12 of the generator 100 longitudinally provides a balanced supporting force to the middle position of the movable shell 60.

In one embodiment, the top of the side edge 651 of the fixed shell 65 has an upper end surface 6512; the end of the first side edge 62 of the movable shell 60 is provided with a lower end surface 621, and the upper end surface 6512 and the lower end surface 621 are arranged in a staggered manner.

In one embodiment, the second side edge 63 is divided into at least 3 segments, and each segment of the second side edge 63 is provided with a hook 631 matching the buckle 64.

To further understand the present invention, the present invention also provides a reset method of a self-resetting suspended magnetic generator, including the steps of:
a. Arranging a driving hole 311 on a top cover 31, so that an external force can apply a pushing force to a return part 12 through the driving hole 311;
b. Magnetically adsorbing the return part 12 and the top cover 31, so that the return part 12 is freely magnetically adsorbed to the top cover 31. In the state where the return part 12 is pushed and the pushing force is greater than the magnetic attraction between the return part 12 and the top cover 31, the return part 12 is clamped by the dual forces of the pushing force and the magnetic attraction and moves away from the top cover 31 in a suspended manner; when the pushing force is equal to the magnetic attraction, the return part 12 can stay suspended;
c. Reducing or removing the pushing force, so that when the pushing force is less than the magnetic attraction, the return part 12 moves towards the top cover 31 in a suspended manner and resets.

To further understand the present invention, the present invention also provides a power generation method of a suspended magnetic generator, including the steps of:
I. Applying an external force to drive a return part 12 through a driving hole 311, and the external force is greater than the adsorption force between the return part 12 and a top cover 31, thereby ejecting and driving the return part 12 to separate from the top cover 31 and move along a hollow channel 201 of a hollow coil 20 away from the top cover 31, and disturbing the hollow coil 20 to generate an induced electromotive force once;
II. Removing the corresponding external force, and the return part 12 moves towards the top cover 31 under the action of the magnetic adsorption force with the top cover 31, thereby disturbing the hollow coil 20 to generate an induced electromotive force again.

In particular, in some embodiments, the energy storage part 13 can be made of rubber, which has elasticity and can reduce noise during operation; therefore, when the energy storage part 13 is made of rubber, the energy storage part 13 and the driving part 11 are integrally formed to simplify the structure; therefore, in this implementation structure, the rubber part is both the energy storage part 13 and the driving part 11.

Those skilled in the art should understand that the embodiments of the present invention shown in the above description and drawings are only examples and do not limit the present invention. The purpose of the present invention has been fully and effectively achieved. The functional and structural principles of the present invention have been shown and explained in the embodiments, and various changes or modifications can be made to the embodiments of the present invention without departing from the principles.

## Claims

1. A self-resetting suspended magnetic generator, **characterized by** comprising:
a hollow coil, wherein the hollow coil defines a hollow channel;
a suspended magnetic assembly, wherein the suspended magnetic assembly comprises a driving member and a return member, at least one of the driving member and the return member is a permanent magnet; and
a shell, wherein the shell includes a top cover, a bottom cover and a power generation cavity defined by the top cover and the bottom cover, the hollow coil is accommodated in the power generation cavity, wherein the top cover has a driving hole connected to the power generation cavity, wherein when the hollow coil is accommodated in the power generation cavity, the driving hole is connected to the hollow channel to form a suspended magnetic channel, wherein the driving member extends from the driving hole of the top cover into the suspended magnetic channel, wherein the return member is arranged in the suspended magnetic channel, and is magnetically attracted to the top cover and maintained in an initial position when at least one of the driving member and the return member is a permanent magnet, wherein when the driving member is driven by force to move the return member along the suspended magnetic channel, a change in the magnetic flux of the hollow coil is formed to generate electric energy, and the corresponding return member is suspended in the suspended magnetic channel under the magnetic attraction of the top cover, so that it returns to the initial position when the force on the driving member is removed, thereby forming a change in the magnetic flux of the hollow coil again to generate electric energy.

2. The self-resetting suspended magnetic generator according to claim 1, wherein the top cover further includes a driving tube extending from the periphery of the driving hole toward the bottom cover, wherein one end of the driving tube where the driving hole is located is the top end of the driving tube, and the other end of the driving tube is the bottom end of the driving tube, wherein the driving member extends into the driving tube from the top end of the driving tube, and drives the return member located at the bottom end of the driving tube to move in a direction away from the top cover under a force-driven state, wherein when the force on the driving member is removed, the return member is attracted to the top cover under the action of magnetic attraction and moves in the direction of the top cover, thereby being abutted against the bottom end of the driving tube.

3. The self-resetting suspended magnetic generator according to claim 1, wherein the bottom cover is a closed cover, wherein the movement stroke of the suspended magnetic component satisfies that the magnetic attraction force between the return member and the top cover is greater than the magnetic attraction force between the return member and the bottom cover.

4. The self-resetting suspended magnetic generator according to claim 1, wherein the bottom cover has a bottom opening connected to the power generation chamber, and wherein the movement stroke of the suspended magnetic component satisfies that the magnetic attraction force between the return member and the top cover is greater than the magnetic attraction force between the return member and the bottom cover.

5. The self-resetting suspended magnetic generator according to claim 4, wherein the projection of the driving hole toward the bottom cover is located in the bottom opening.

6. The self-resetting suspended magnetic generator according to claim 1, wherein the return member is a permanent magnet.

7. The self-resetting suspended magnetic generator according to claim 6, wherein the driving member is a non-magnetic conductive body and abuts against the return member.

8. The self-resetting magnetic suspension generator according to claim 1, wherein the return member and the drive member are both permanent magnets.

9. The self-resetting suspended magnetic generator according to claim 8, wherein the return member and the drive member are an integrated structure.

10. According to the self-resetting suspended magnetic generator of claim 1, the driving member is a permanent magnet, and the return member is a magnetic conductor to conduct the magnetic force of the driving member to ensure the magnetic attraction with the top cover.

11. According to the self-resetting suspended magnetic generator according to claim 1 or 2, the suspended magnetic assembly further comprises a force storage member, wherein the force storage member accumulates potential energy and forms a force displacement of the driving member before the driving member drives the return member under force and overcomes the magnetic attraction between the return member and the top cover.

12. The self-resetting suspended magnetic generator according to claim 11, wherein the force storage member is arranged between the driving member and the return member.

13. The self-resetting suspended magnetic generator according to claim 11, wherein the force storage member is arranged at an end of the driving member away from the return member.

14. According to the self-resetting suspended magnetic generator of claim 12, one end of the driving member close to the return member has a driving groove recessed toward the other end of the driving member, and the force storage member is accommodated in the driving groove and presses the return member.

15. The self-resetting suspended magnetic generator according to claim 1 or 2, wherein the hollow coil is arranged in a ring shape.

16. The self-resetting suspended magnetic generator according to claim 15, wherein the driving member is configured as a cylinder or a quasi-cylindrical body, and the return member is configured as a disc.

17. The self-resetting suspended magnetic generator according to claim 16, wherein the diameter of the return member is larger than the aperture of the drive hole.

18. The self-resetting suspended magnetic generator according to claim 16, wherein the end of the driving member away from the return member is configured to be tapered to facilitate pressing the self-resetting suspended magnetic generator.

19. The self-resetting suspended magnetic generator according to claim 1 or 2, wherein the hollow coil is configured to be rectangular or irregular in shape.

20. According to the self-resetting suspended magnetic generator of claim 1, the top cover includes a first magnetic wall and a second magnetic wall and a third magnetic wall extending downward from the first magnetic wall, and the center of the first magnetic wall is hollowed out to form the driving hole.

21. The self-resetting suspended magnetic generator according to claim 1, wherein the bottom cover comprises a bottom magnetic wall and a side magnetic wall extending upward from an edge of the bottom magnetic wall perpendicular to the bottom magnetic wall, wherein the second magnetic wall of the top cover and the side magnetic wall of the bottom cover are directly abutted or close to each other.

22. A self-powered selfie stick is **characterized by** comprising:
a clamping portion;
a handle portion, wherein the clamping portion is mounted on the handle portion; and
a self-resetting generator, wherein the self-resetting generator is arranged on the handle portion,
and the self-resetting generator is electrically connected to a communication circuit, and the communication circuit can transmit wireless signals to control a mobile terminal device clamped in the clamping portion to take pictures, wherein when the corresponding control key of the self-generating selfie stick is pressed, the self-resetting generator is linked to generate electrical energy to power the communication circuit, so that the communication circuit sends a shooting instruction to the mobile terminal device, and when the control key is pressed and released, the self-resetting generator automatically returns to an initial state to prepare for the next shooting operation.

23. The self-generating selfie stick according to claim 22, wherein the self-resetting generator comprises a hollow coil, a suspended magnetic assembly and a shell, wherein the suspended magnetic assembly comprises a driving member and a return member, at least one of the driving member and the return member is a permanent magnet, and the driving member is linked to the control key, wherein the shell comprises a top cover, a bottom cover and a power generation cavity defined by the top cover and the bottom cover, the hollow coil is accommodated in the power generation cavity, wherein the top cover has a driving hole connected to the power generation cavity, and the hollow coil defines a hollow channel, wherein when the hollow coil is accommodated in the power generation cavity, the The driving hole is connected to the hollow channel to form a suspended magnetic channel, wherein the return member is arranged in the suspended magnetic channel, and is magnetically attracted to the top cover and maintained in an initial position when at least one of the driving member and the return member is a permanent magnet, wherein the driving member extends into the suspended magnetic channel from the driving hole of the top cover, and drives the return member to move along the suspended magnetic channel when the corresponding control key is pressed, so as to form a change in the magnetic flux of the hollow coil to generate electric energy, and the corresponding return member is suspended in the suspended magnetic channel under the magnetic attraction of the top cover, so as to return to the initial position when the force on the driving member is removed.

24. A power generation method of the self-resetting suspended magnetic generator is **characterized by** comprising the steps of:
A. Initially, a return member is adsorbed by a magnetic attraction with a top cover and is kept in an initial position;
B. Applying force to a driving member to drive the return member to move along a suspended magnetic channel, thereby forming a change in the magnetic flux of a hollow coil to generate the first electrical energy, and the return member is suspended in the suspended magnetic channel under the magnetic attraction of the top cover;
C. When the return member moves to an end position, the force applied to the driving member is cancelled, and the return member automatically returns to the initial position under the magnetic attraction with the top cover.

25. The power generation method of the self-resetting suspended magnetic generator according to claim 24, wherein in the step (A), the return member is magnetically attracted to the inner side of the top cover and centered at the center position of the top cover.

26. According to the power generation method of the self-resetting suspended magnetic generator according to claim 24, in the step (A), one side of the return member is magnetically attracted to the inner side of the top cover, while the other side is left empty, so that it can be suspended and fixed by magnetic force only without a fixed connection device.

27. According to the power generation method of the self-resetting suspended magnetic generator according to claim 24, in the step (A), a driving hole is provided at the center position of the top cover, wherein the driving hole is concentrically arranged with the return member.

28. The power generation method of the self-resetting suspended magnetic generator according to claim 24, wherein in the step (B), the return member moves axially along the suspended magnetic channel.

29. According to the power generation method of the self-resetting suspended magnetic generator according to claim 24, wherein initially, the return member and the top cover are magnetically adsorbed together, and when the applied force exceeds the magnetic adsorption force between the return member and the top cover, the driving member suddenly ejects the return member along the suspended magnetic channel, so that the hollow coil can instantly generate an induction pulse.

30. According to the power generation method of the self-resetting suspended magnetic generator according to claim 24, wherein in the step (B), the movement of the return member along the suspended magnetic channel is greater than or equal to 0.5 mm and less than or equal to 6 mm.

31. The power generation method of the self-resetting suspended magnetic generator according to claim 24, wherein in the step (B), the movement speed of the return member is greater than 0.05 m/s.

32. According to the power generation method of the self-resetting suspended magnetic generator according to claim 24, in the step (C), the return member returns to the initial position to disturb the magnetic flux change of the hollow coil again to generate a second electric energy.

33. The self-resetting suspended magnetic generator is **characterized by** comprising:
a hollow coil, wherein the hollow coil defines a hollow channel;
a top cover, wherein the hollow coil is accommodated below the top cover, wherein the top cover has a driving hole communicating with the hollow channel, and a driving tube extending downward from the periphery of the driving hole, wherein an end of the driving tube away from the driving hole is the bottom end of the driving tube, and wherein the hollow coil is arranged around the driving tube; a return member, wherein the return member is a permanent magnet, the return member is arranged below the top cover and is magnetically attracted to the bottom end of the driving tube and
maintained at an initial position, wherein the return member makes axial movement relative to the hollow coil when driven by force, and the corresponding return member is suspended below the top cover under the magnetic attraction with the top cover, so that it automatically returns to the initial position when the force is removed.

34. The self-resetting suspended magnetic generator according to claim 33, wherein the length of the driving tube is set to be greater than or equal to 0.1 mm and less than or equal to 15 mm.

35. According to the self-resetting suspended magnetic generator of claim 33, the movement stroke of the return member is greater than or equal to 0.5 mm and less than or equal to 6 mm.

36. According to the self-resetting suspended magnetic generator according to claim 33, when the return member is driven, a side of the return member facing away from the drive hole will protrude from a side of the hollow coil facing away from the drive hole.

37. The self-resetting suspended magnetic generator according to claim 33, wherein the magnet volume of the return member is set to be greater than 25 cubic millimeters.

38. The self-resetting suspended magnetic generator according to claim 33, wherein the size of the return member is equal to the total surface area of the bottom of the drive tube.

39. The self-resetting suspended magnetic generator according to claim 33, wherein the number of turns of the hollow coil is set to be greater than 250 and less than 1500.

40. The self-resetting suspended magnetic generator according to claim 33, wherein when the self-resetting suspended magnetic generator is installed in a corresponding housing, the spacing between the return member and the corresponding housing is greater than 0.1 mm.

41. According to the self-resetting suspended magnetic generator as described in claim 33, the top cover includes a first magnetic wall and a second magnetic wall and a third magnetic wall extending downward from the first magnetic wall, and the center of the first magnetic wall is hollowed out to form the driving hole.

42. According to the self-resetting suspended magnetic generator according to claim 33, the first magnetic wall has an inner side facing the driving hole and an outer side opposite to the inner side, the second magnetic wall extends downward from the outer side of the first magnetic wall, and the third magnetic wall extends downward from the inner side of the first magnetic wall, wherein the hollow coil is accommodated between the second magnetic wall and the third magnetic wall.

43. The self-resetting suspended magnetic generator according to any one of claims 33 to 42, wherein the hollow coil is arranged in a ring shape.

44. The reset method of the self-resetting suspended magnetic generator is **characterized by** comprising the steps of:
a. a driving hole is provided on a top cover so that an external force can apply a driving force to a return member through the driving hole;
b. magnetically attracting the return member and the top cover, so that the return member can be freely magnetically attracted to the top cover, and when the return member is pushed and the pushing force is greater than the magnetic attraction between the return member and the top cover, the return member is clamped to move in a suspended manner away from the top cover under the dual forces of the pushing force and the magnetic attraction; wherein when the pushing force is equal to the magnetic attraction, the return member can be suspended and still;
c. reduce or cancel the driving force, so that when the driving force is smaller than the magnetic attraction force, the return member moves in a suspended manner toward the top cover and resets.

45. The resetting method of a self-resetting suspended magnetic generator according to claim 44, wherein in the step (a), the return member abuts against the top cover and is arranged concentrically with the drive hole.

46. According to the resetting method of the self-resetting suspended magnetic generator according to claim 44, a driving tube is also arranged between the return member and the driving hole, one side of the return member abuts against the driving tube, and the other side is suspended.

47. The resetting method of a self-resetting suspended magnetic generator according to claim 44, wherein the periphery of the return member abuts against the periphery of the drive hole.

48. According to the resetting method of the self-resetting suspended magnetic generator according to claim 44, wherein in the step (b), a driving force is applied to the return member by a driving member, and when the driving force exceeds the magnetic adsorption force between the return member and the top cover, the driving member suddenly ejects the return member along a suspended magnetic channel so that the return member has a higher movement acceleration.

49. According to the resetting method of the self-resetting suspended magnetic generator according to claim 44, wherein in the step (b), a hollow coil is arranged concentrically with the return member so that when the return member moves in a suspended manner in a direction away from the top cover, the hollow coil is disturbed to instantaneously generate an induction pulse.

50. According to the resetting method of the self-resetting suspended magnetic generator as described in claim 49, wherein in the step (c), when the return member moves in a suspended manner toward the direction of the top cover to reset, the hollow coil is disturbed to instantly generate an induction pulse again.

51. A suspended magnetic generator, **characterized in that** the suspended magnetic generator includes a top cover, a return member and a hollow coil, wherein the top cover has a driving hole, wherein the return member initially abuts against the top cover, and the hollow coil has a hollow channel. When an external force passes through the driving hole and drives the return member, the return member moves like a piston along the hollow channel in a direction away from the driving tube, thereby disturbing the hollow coil to generate an induction pulse. The suspended magnetic generator includes a driving tube, one end of the driving tube abuts against the driving hole, and the other end of the driving tube abuts against the return member, and the hollow coil is arranged around the driving tube.

52. According to the suspended magnetic generator according to claim 51, when the external force is removed, the return member freely returns to an initial position under the action of the magnetic force and abuts against the driving tube, wherein during the resetting process of the return member, the hollow coil is disturbed to generate an induction pulse again.

53. The suspended magnetic generator according to claim 51, wherein the drive hole, the drive tube, the return member and the hollow coil are arranged concentrically.

54. According to the suspended magnetic generator of claim 53, one end of the driving tube abuts against the periphery of the driving hole, and the other end of the driving tube abuts against the periphery of the return member.

55. According to the suspended magnetic generator of claim 53, the part of the return member other than the position abutting against the driving tube is the driven part of the return member, wherein the driving tube is hollow, and the corresponding external force passes through the driving tube and acts on the driven part of the return member, thereby driving the return member to move.

56. According to the suspended magnetic generator of claim 51, the suspended magnetic generator includes a driving member, wherein the driving member is movably arranged in a cavity formed by the driving hole and the driving tube, wherein when subjected to external force, the driving member drives the return member to move in a direction away from the driving tube, and when the external force is removed, the return member is reset and pushes the driving member back to an initial position.

57. According to the suspended magnetic generator of claim 51, the return member is magnetically adsorbed to the drive tube at the beginning, and when the external force is greater than the magnetic adsorption force between the return member and the drive tube, the external force will be converted into an instantaneous ejection force applied to the return member to eject the return member away from the drive tube, thereby causing the hollow coil to generate a higher induced electromotive force based on the high-speed ejection.

58. A method for generating electricity using a suspended magnetic generator, **characterized in that** the suspended magnetic generator comprises a top cover, a return member and a hollow coil, wherein the top cover has a driving hole, the return member is magnetically adsorbed on the top cover, the hollow coil is sleeved on the outer periphery of the return member, and the center of the hollow coil has a hollow channel, wherein the method for generating electricity using the suspended magnetic generator comprises the steps of:
I. Apply an external force through the driving hole to drive the return member, and the external force is greater than the attraction force between the return member and the top cover, so as to eject and drive the return member to separate from the top cover and move along the hollow channel in a direction away from the top cover, thereby disturbing the hollow coil to generate a primary induced electromotive force;
II. The corresponding external force is cancelled, and the return member moves toward the top cover under the action of the magnetic attraction force with the top cover to disturb the hollow coil to generate an induced electromotive force again.

59. According to the power generation method of the suspended magnetic generator according to claim 58, the return member is arranged concentrically with the drive hole.

60. According to the power generation method of the suspended magnetic generator of claim 58, the return member performs piston-like motion along the hollow channel.

61. The power generation method of a suspended magnetic generator according to claim 58, wherein in the step (II), the return member moves toward the top cover and is re-attracted to the top cover.

62. According to the power generation method of the suspended magnetic generator according to claim 58, the top cover and the return member are arranged in layers and are only attracted by magnetic force.

63. According to the power generation method of the suspended magnetic generator according to claim 59, the periphery of the drive hole is arranged opposite to the periphery of the return member.

64. According to the power generation method of the suspended magnetic generator according to claim 58, when the return member is away from the top cover, the return member can maintain a suspended state under the clamping of the dual forces of external force and magnetic attraction; and when the corresponding external force is withdrawn, the return member automatically returns to the initial position from the end position under the magnetic attraction with the top cover.

65. A blind-zone-free pressing driving device is **characterized by** comprising:
a generator;
a movable shell, wherein the movable shell comprises a panel, a second side edge and a central axis, wherein the second side edge extends downward from the panel, and the central axis is disposed at the center of the panel; and
a fixed shell, wherein the movable shell is movably arranged above the fixed shell, wherein the generator is accommodated between the movable shell and the fixed hole and abutted by the central axis to provide a balanced supporting force for the movable shell, wherein when the movable shell is driven by an external force, the second side of the movable shell can be pivotally and movably connected to the fixed shell, and the generator is driven by the movable shell to generate electrical energy.

66. According to the blind-zone-free pressing drive device of claim 65, the generator comprises a hollow coil, a suspended magnetic component and a shell, wherein the hollow coil defines a hollow channel, wherein the suspended magnetic component comprises a driving member and a return member, at least one of the driving member and the return member is a permanent magnet, wherein the shell comprises a top cover, a bottom cover and a power generation cavity defined by the top cover and the bottom cover, the hollow coil is accommodated in the power generation cavity, wherein the top cover has a driving hole connected to the power generation cavity, wherein when the hollow coil is accommodated in the power generation cavity, the driving hole is connected to the hollow channel to form a suspended magnetic channel, which the driving member extends from the driving hole of the top cover into the suspended magnetic channel, wherein the return member is arranged in the suspended magnetic channel, and is magnetically attracted to the top cover and maintained in an initial position when at least one of the driving member and the return member is a permanent magnet, wherein the driving member is abutted against the central axis, so that when the movable shell is driven by force, the return member is driven by the central axis and linked to move along the suspended magnetic channel to form a change in the magnetic flux of the hollow coil to generate electric energy, and the corresponding return member is suspended in the suspended magnetic channel under the magnetic attraction of the top cover, so as to return to the initial position when the force on the movable shell is removed.

67. A method for power generation by pressing without blind area is **characterized by** comprising the steps of:
A. In static state, a generator provides a balancing support force to the middle of a movable shell;
B. Press the movable shell so that a second side located at the edge of the movable shell is pivotally connected to a buckle of a fixed shell below the movable shell, thereby forming a driving state in which there is no blind area pressing on the surface of the movable shell to drive the generator to generate electrical energy.

68. According to the blind-zone-free pressing power generation method of claim 67, in the step (A), a force storage member of the generator supports a central axis of the movable shell to form a state in which the movable shell is balanced and supported by the generator.

69. According to the blind-zone-free pressing power generation method of claim 67, in the step (A), a return member of the generator provides a balancing support force longitudinally to the middle position of the movable shell.

70. According to the blind-zone-free pressing power generation method of claim 67, the top of the side of the fixed shell has an upper end surface; the end of the first side of the movable shell is provided with a lower end surface, and the upper end surface and the lower end surface are arranged alternately.

71. According to the blind-zone-free pressing power generation method of claim 67, the second side is divided into at least three sections, and each section of the second side is provided with a hook matching the buckle.
